# EUROPEAN PATENT SPECIFICATION

(11) **EP 4 156 522 B1**
(45) Date of publication and mention of the grant of the patent: **26.08.2026**
(21) Application number: 21807567.9
(22) Date of filing: 08.05.2021
(51) Int. Cl.: H03M 13/11, H03M 13/00, H04L 1/00, H04L 1/1812, H04L 1/1829

(54) **RATE MATCHING METHOD FOR LDPC CODE, AND COMMUNICATION DEVICE**
RATENANPASSUNGSVERFAHREN FÜR LDPC-CODE UND KOMMUNIKATIONSVORRICHTUNG
PROCÉDÉ DE MISE EN CORRESPONDANCE DE DÉBITS POUR CODE LDPC ET DISPOSITIF DE COMMUNICATION

(30) Priority: 22.05.2020 CN 202010439966
(43) Date of publication of application: 29.03.2023
(73) Proprietor: HUAWEI TECHNOLOGIES CO., LTD., Shenzhen, Guangdong 518129 (CN)
(72) Inventor: LIN, Wei, Shenzhen, Guangdong 518129 (CN); WANG, Hui, Chengdu, Sichuan 611756 (CN); LEI, Xianfu, Chengdu, Sichuan 611756 (CN); GAN, Ming, Shenzhen, Guangdong 518129 (CN); TANG, Xiaohu, Chengdu, Sichuan 610031 (CN)
(74) Representative: Pfenning, Meinig & Partner mbB
(86) International application number: PCT/CN2021/092348
(87) International publication number: WO 2021/233141

(56) References cited:
- CN-A- 111 034 056
- US-A1- 2009 307 562
- US-A1- 2010 325 520
- US-B1- 9 755 665
- CAO Y ET AL: "Degree distribution based HARQ for irregular LDPC", ELECTRONICS LETTERS, THE INSTITUTION OF ENGINEERING AND TECHNOLOGY, GB, vol. 42, no. 6, 16 March 2006 (2006-03-16), pages 363 - 364, XP006026351, ISSN: 0013-5194, DOI: 10.1049/EL:20063676
- "Annex F HT LDPC matrix definitions", vol. 802.11md drafts; 802.11 drafts; 802.11m drafts, no. D2.1, 31 January 2019 (2019-01-31), pages 1 - 4, XP068149555, Retrieved from the Internet <URL:www.ieee802.org/11/private/Draft_Standards/11md/REVmd_An_F.fm.rtf> [retrieved on 20190131]
- HUI WANG ET AL: "On the LLR criterion based shortening design for LDPC codes", 2016 ANNUAL CONFERENCE ON INFORMATION SCIENCE AND SYSTEMS (CISS), IEEE, 16 March 2016 (2016-03-16), pages 87 - 92, XP032895850, DOI: 10.1109/CISS.2016.7460482
- JIA MINLI ET AL: "Reliability-based subpacket transmission for hybrid ARQ with LDPC codes", 5TH INTERNATIONAL CONFERENCE ON COMMUNICATIONS, CIRCUITS AND SYSTEMS - 11-13 JULY 2007, KOKURA, JAPAN, IEEE, PISCATAWAY, NJ, USA, 11 July 2007 (2007-07-11), pages 80 - 84, XP032209845, ISBN: 978-1-4244-1473-4, DOI: 10.1109/ICCCAS.2007.6247578
- LEI WANG, XIAOHUI DING, CHENG LI: "A New Method Based on the RB-HARQ in Secure Transmission", INFORMATION ON TECHNOLOGY AND NETWORK SECURITY, vol. 38, no. 1, 31 January 2019 (2019-01-31), pages 69 - 73, XP055869764, ISSN: 2096-5113, DOI: 10.19358/j.issn.2096-5133.2019.01.014
- DU HAO-YANG, WANG CHENG-GUI, LUAN YA-TING: "A HARQ Strategy Based on Decoding Reliability in LDPC Codes", RADIO COMMUNICATIONS TECHNOLOGY, vol. 42, no. 5, 31 October 2016 (2016-10-31), XP055869766, ISSN: 1003-3114

## Description

### TECHNICAL FIELD

This application relates to the field of channel coding, and more specifically, to an LDPC rate matching method, a related communication apparatus, computer-readable storage medium and program.

### BACKGROUND

In the field of channel coding, a low-density parity check (low-density parity check, LDPC) code is one of most mature and widely applied channel coding schemes. LDPC has performance close to the Shannon limit, and has many advantages. Therefore, IEEE 802.11n, 802.11ac, 802.11ax, and other protocols propose that the LDPC be used as a standard channel coding scheme for a wireless local area network (wireless local area network, WLAN). Currently, 12 LDPC check matrices are used in the 802.11ac/ax standard, three code lengths are supported, and each code length supports four code rates. A transmit device selects a corresponding check matrix of the 12 check matrices based on a target code length and code rate, to perform LDPC encoding.

To further improve a throughput rate of a communication system, a next-generation WLAN standard 802.11be is proposed, and an incremental redundancy-hybrid automatic repeat request (incremental redundancy-hybrid automatic repeat request, IR-HARQ) mechanism is introduced based on 802.11ax. The IR-HARQ mechanism expects to increase a redundant bit through retransmission and reduce a channel coding rate, to improve decoding performance of a receive end.

However, an LDPC coding scheme used in a current WLAN standard cannot meet a requirement of obtaining a performance gain by continuously adding redundant bits through retransmission in an IR-HARQ mechanism, and decoding performance is low.

CAO Y ET AL: "Degree distribution based HARQ for irregular LDPC", ELECTRONICS LETTERS, THE INSTITUTION OF ENGINEERING AND TECHNOLOGY, GB, vol. 41, no. 6, 16 March 2006, pages 363-364, describes a HARQ scheme using irregular LDPC codes where for retransmissions, subsets of the initially transmitted codeword bits are sent based on a priority ordering related to the degrees of the variable nodes, i.e. exploiting the property that high degree variable nodes are more reliable than low degree variable nodes, thus low degree variable nodes should be prioritized for retransmission to boost the probability of decoding success.

"Annex F HT LDPC matrix definitions", IEEE DRAFT; REVMD_AN_F.FM, IEEE-SA, vol. 802.11 md drafts; no. D2.1, 31 January 2019, pages 1-4, contains the LDPC parity-check matrix definitions for the IEEE 802.11 standard.

HUI WANG ET AL: "On the LLR criterion based shortening design for LDPC codes", 2016 ANNUAL CONFERENCE ON INFORMATION SCIENCE AND SYSTEMS (CISS), IEEE, 16 March 2016, pages 87-92, describes an algorithm for obtaining a reliability ordering of bits in an irregular LDPC code, the obtained reliability ordering is used to determine bits most suitable for shortening.

JIA MINLI ET AL: "Reliability-based subpacket transmission for hybrid ARQ with LDPC codes", 5TH INTERNATIONAL CONFERENCE ON COMMUNICATIONS. CIRCUITS AND SYSTEMS, 11-13 July 2007, pages 80-84, describes a HARQ scheme using irregular LDPC codes, considers the instantaneous LLR absolute values of subpackets at the receiver after iterative decoding as a criterion for prioritizing retransmissions.

United States patent application US 2009/307562 A1 relates to a method and transmitter for matching a size of codeword encoded by LDPC code to a size of a transmission channel and in a mobile communication system.

United States patent application US 2010/325520 A1 provides a radio communication device which can obtain the maximum improvement effect of the error rate characteristic by repetition when an LDPC code is used as an error correction code.

### SUMMARY

This application provides an LDPC rate matching method, a related communication apparatus, computer-readable storage medium and program, to improve decoding performance. The invention is defined by the appended claims.

According to a first aspect, this application provides an LDPC rate matching method. The method includes: A transmit end performs rate matching on a first LDPC codeword at a first code rate based on an order of repetition priorities of K information bits of a mother code of an LDPC in rate matching, to obtain a second LDPC codeword at a second code rate, where K is a positive integer. The transmit end sends the second LDPC codeword.

In embodiments of this application, a priority at which an information bit is repeated in a rate matching process is referred to as a repetition priority of the information bit.

In the technical solutions of this application, the transmit end repeats information bits of an LDPC codeword based on repetition priorities of the information bits in the rate matching process during retransmission, to obtain a performance gain at a receive end. The order of repetition priorities of information bits is determined based on sensitivity of LDPC codewords. Therefore, in the order of repetition priorities, an information bit with higher sensitivity has a lower repetition priority, and an information bit with lower sensitivity has a higher repetition priority. Therefore, when the transmit end repeats the information bits of the LDPC codeword, an information bit with lower sensitivity is repeated first, so that decoding performance of the receive end can be improved.

With reference to the first aspect, in some implementations of the first aspect, that a transmit end performs rate matching on a first LDPC codeword at a first code rate based on an order of repetition priorities of K information bits includes:

The transmit end repeatedly sends, in descending order of repetition priorities, L information bits in a first information bit set in the first LDPC codeword based on a quantity L of bits that need to be repeated and the order of repetition priorities of the K information bits. A repetition priority of an information bit with a lowest repetition priority in the L information bits of the first information bit set is higher than or equal to a repetition priority of a remaining information bit in the first LDPC codeword other than the information bits in the first information bit set, L ≤ K, and L is an integer.

It should be understood that the first information bit set is L information bits with highest repetition priorities in all information bits of the first LDPC codeword that are sorted in descending order of repetition priorities.

With reference to the first aspect, in some implementations of the first aspect, the repetition priorities of the K information bits are sorted as follows:
an order of repetition priorities of columns, corresponding to information bits, in a mother matrix of a check matrix of an LDPC whose quantity of information bits is K, mother code length is N, and code rate is R, where each column in the mother matrix corresponds to z codeword bits of the LDPC, z = N/n, n is a total quantity of columns included in the mother matrix, and the check matrix of the LDPC is obtained by extending the mother matrix; and each element i in the mother matrix indicates a cyclic shift matrix of z × z, i indicates a cyclic shift value, i ≥ 0, i is an integer, N ≥ K, N is an integer, and R = K/N.

With reference to the first aspect, in some implementations of the first aspect, the mother code length is 1944, the code rate is 1/2, and in descending order of repetition priorities, repetition priorities of the columns, in the mother matrix, corresponding to the information bits are sorted as follows: 10, 6, 8, 11, 4, 3, 12, 7, 2, 5, 9, and 1, where each element a in the sorting indicates an a^{th} column of the mother matrix.

With reference to the first aspect, in some implementations of the first aspect, the mother code length is 1296, the code rate is 1/2, and in descending order of repetition priorities, repetition priorities of the columns, in the mother matrix, corresponding to the information bits are sorted as follows: 8, 12, 7, 3, 11, 10, 4, 6, 2, 5, 9, and 1, where each element a in the sorting indicates an a^{th} column of the mother matrix.

With reference to the first aspect, in some implementations of the first aspect, the mother code length is 648, the code rate is 1/2, and in descending order of repetition priorities, repetition priorities of the columns, in the mother matrix, corresponding to the information bits are sorted as follows: 8, 6, 12, 11, 2, 3, 10, 7, 4, 1, 5, and 9, where each element a in the sorting indicates an a^{th} column of the mother matrix.

With reference to the first aspect, in some implementations of the first aspect, the mother code length is 1944, the code rate is 2/3, and in descending order of repetition priorities, repetition priorities of the columns, in the mother matrix, corresponding to the information bits are sorted as follows: 16, 8, 15, 12, 9, 10, 14, 6, 13, 11, 7, 5, 1, 2, 3, and 4, where each element a in the sorting indicates an a^{th} column of the mother matrix.

With reference to the first aspect, in some implementations of the first aspect, the mother code length is 1296, the code rate is 2/3, and in descending order of repetition priorities, repetition priorities of the columns, in the mother matrix, corresponding to the information bits are sorted as follows: 16, 9, 12, 7, 10, 8, 11, 14, 13, 15, 6, 4, 5, 1, 2, and 3, where each element a in the sorting indicates an a^{th} column of the mother matrix.

With reference to the first aspect, in some implementations of the first aspect, the mother code length is 648, the code rate is 2/3, and in descending order of repetition priorities, repetition priorities of the columns, in the mother matrix, corresponding to the information bits are sorted as follows: 16, 9, 12, 7, 10, 8, 11, 14, 13, 15, 6, 4, 5, 1, 2, and 3, where each element a in the sorting indicates an a^{th} column of the mother matrix.

With reference to the first aspect, in some implementations of the first aspect, the mother code length is 1944, the code rate is 3/4, and in descending order of repetition priorities, repetition priorities of the columns, in the mother matrix, corresponding to the information bits are sorted as follows: 12, 16, 11, 10, 14, 17, 15, 8, 13, 18, 7, 9, 1, 2, 3, 4, 5, and 6, where each element a in the sorting indicates an a^{th} column of the mother matrix.

With reference to the first aspect, in some implementations of the first aspect, the mother code length is 1296, the code rate is 3/4, and in descending order of repetition priorities, repetition priorities of the columns, in the mother matrix, corresponding to the information bits are sorted as follows: 9, 11, 13, 15, 17, 8, 10, 12, 14, 16, 18, 1, 2, 3, 4, 5, 6, and 7, where each element a in the sorting indicates an a^{th} column of the mother matrix.

With reference to the first aspect, in some implementations of the first aspect, the mother code length is 648, the code rate is 3/4, and in descending order of repetition priorities, repetition priorities of the columns, in the mother matrix, corresponding to the information bits are sorted as follows: 18, 13, 15, 16, 12, 14, 17, 10, 6, 7, 8, 11, 9, 1, 2, 3, 4, and 5, where each element a in the sorting indicates an a^{th} column of the mother matrix.

With reference to the first aspect, in some implementations of the first aspect, the mother code length is 1944, the code rate is 5/6, and in descending order of repetition priorities, repetition priorities of the columns, in the mother matrix, corresponding to the information bits are sorted as follows: 12, 14, 15, 17, 19, 13, 20, 11, 16, 18, 1, 2, 3, 4, 5, 6, 7, 8, 9, and 10, where each element a in the sorting indicates an a^{th} column of the mother matrix.

With reference to the first aspect, in some implementations of the first aspect, the mother code length is 1296, the code rate is 5/6, and in descending order of repetition priorities, repetition priorities of the columns, in the mother matrix, corresponding to the information bits are sorted as follows: 17, 20, 19, 18, 1, 2, 3, 4, 5, 6, 7, 8, 9, 10, 11, 12, 13, 14, 15, and 16, where each element a in the sorting indicates an a^{th} column of the mother matrix.

With reference to the first aspect, in some implementations of the first aspect, the mother code length is 648, the code rate is 5/6, and in descending order of repetition priorities, repetition priorities of the columns, in the mother matrix, corresponding to the information bits are sorted as follows: 13, 1, 2, 3, 4, 5, 6, 7, 8, 9, 10, 11, 12, 14, 15, 16, 17, 18, 19, and 20, where each element a in the sorting indicates an a^{th} column of the mother matrix.

With reference to the first aspect, in some implementations of the first aspect, that the transmit end repeats, in descending order of repetition priorities based on the quantity L of bits that need to be repeated and the order of repetition priorities of the K information bits, first L information bits in the order of repetition priorities in the first LDPC codeword includes:

If L < z, the transmit end selects and repeats L information bits from z information bits, in the check matrix, corresponding to a column with a highest repetition priority in the mother matrix;
if L = m × z, the transmit end selects and repeats, in descending order of repetition priorities from the mother matrix, mz information bits, in the check matrix, corresponding to first m columns with higher repetition priorities, where m is a positive integer; and
if (m - 1) × z < L < m × z, the transmit end selects and repeats, in descending order of repetition priorities from the mother matrix, (m - 1) × z information bits, in the check matrix, corresponding to first (m - 1) columns with higher repetition priorities and p information bits in z information bits, in the check matrix, corresponding to an m^{th} column, where L = (m - 1) × z + p, p ≥ 1, p is an integer, m > 1, and m is an integer.

With reference to the first aspect, in some implementations of the first aspect, before the transmit end repeatedly sends, in descending order of repetition priorities based on the quantity L of bits that need to be repeated and the order of repetition priorities of the K information bits, L information bits included in the first information bit set in the first LDPC codeword, the method further includes:

The transmit end sends the first LDPC codeword.

Further, that the transmit end repeatedly sends, in descending order of repetition priorities based on a quantity L of bits that need to be repeated and the order of repetition priorities of the K information bits, L information bits included in a first information bit set in the first LDPC codeword includes:
If the first LDPC codeword is not successfully decoded by a receive end, the transmit end repeatedly sends, in descending order of repetition priorities based on a quantity L of bits that need to be repeated and the order of repetition priorities of the K information bits, L information bits included in a first information bit set in the first LDPC codeword.

Further, the method further includes:
if all information bits included in the first LDPC codeword are repeatedly sent and the receive end still does not successfully decode the information bits, the method further includes:

The transmit end sends check bits obtained after puncturing in the first LDPC codeword in an order of puncturing priorities of check bits, where a check bit with a lower puncturing priority is sent first, the puncturing priorities indicate puncturing priorities of (N - K) check bits in rate matching, N is the mother code length of the LDPC, N ≥ K, and N is an integer.

With reference to the first aspect, in some implementations of the first aspect, before the transmit end repeatedly sends, in descending order of repetition priorities based on the quantity L of bits that need to be repeated and the order of repetition priorities of the K information bits, L information bits included in the first information bit set in the first LDPC codeword, the method further includes:

The transmit end sends the first LDPC codeword; and
if the first LDPC codeword is not successfully decoded by a receive end, the transmit end sends check bits that are obtained after puncturing and that are in the first LDPC codeword in an order of priorities of check bits, where a check bit with a lower puncturing priority is sent first, the puncturing priorities indicate puncturing priorities of (N - K) check bits in rate matching, N is the mother code length of the LDPC, N ≥ K, and N is an integer.

Further, that the transmit end repeatedly sends, in descending order of repetition priorities based on a quantity L of bits that need to be repeated and the order of repetition priorities of the K information bits, L information bits included in a first information bit set in the first LDPC codeword includes:
If all check bits, obtained after puncturing, of the first LDPC codeword are sent and the receive end still does not successfully decode the check bits obtained after puncturing, the transmit end sends the information bits of the first LDPC codeword based on the repetition priorities of the K information bits.

According to a second aspect, this application provides a communication apparatus. The communication apparatus has a function of implementing the method according to the first aspect and any one of the possible implementations of the first aspect. The function may be implemented by using hardware or may be implemented by using hardware executing corresponding software. The hardware or the software includes one or more units corresponding to the function.

According to a third aspect, this application provides a communication apparatus. The communication apparatus includes an interface circuit and a processor. The interface circuit is configured to receive computer code or instructions, and transmit the computer code or the instructions to the processor. The processor runs the computer code or the instructions, and the method in the first aspect or any implementation of the first aspect is implemented.

According to a fourth aspect, this application provides a communication device. The communication device includes at least one processor, and the at least one processor is coupled to at least one memory. The at least one memory is configured to store a computer program or instructions. The at least one processor is configured to invoke the computer program or the instructions from the at least one memory and run the computer program or the instructions, so that the communication device performs the method in the first aspect or any possible implementation of the first aspect.

In an example, the communication device may be an encoder.

According to a fifth aspect, this application provides a computer-readable storage medium. The computer-readable storage medium stores computer instructions. When the computer instructions are run on a computer, the method according to the first aspect or any one of the possible implementations of the first aspect is implemented.

According to a sixth aspect, this application provides a computer program product. The computer program product includes computer program code. When the computer program code is run on a computer, the method according to any one of the first aspect or the possible implementations of the first aspect is implemented.

According to a seventh aspect, this application provides a wireless communication system, including the communication device according to the fourth aspect.

### BRIEF DESCRIPTION OF DRAWINGS

FIG. 1 is a check matrix H of an LDPC code;
FIG. 2 is a Tanner graph of a check matrix H of an LDPC code;
(a) and (b) in FIG. 3 are diagrams of system architectures applicable to embodiments of this application;
FIG. 4 is a flowchart of establishing a sensitivity-based sorting table of bit positions according to this application;
FIG. 5 is an image of a function;
FIG. 6 is a schematic flowchart of an LDPC rate matching method according to this application;
FIG. 7 is an application example of a repetition scheme in IR-HARQ according to this application;
FIG. 8 is an application example of a combination of an information bit repetition scheme and a check bit puncturing scheme in IR-HARQ according to this application;
FIG. 9 to FIG. 19 are FER curves and throughput curves of a system under various IR-HARQ transmission policies; and
FIG. 20 is a schematic block diagram of a communication apparatus 1000 according to this application.

### DESCRIPTION OF EMBODIMENTS

The following describes technical solutions of this application with reference to accompanying drawings.

Wireless Local Area Network (wireless local area network, WLAN) transmission standards, such as the Institute of Electrical and Electronics Engineers (institute of electrical and electronics engineers, IEEE) 802.11n/ac/ax/be, are mainly evolved to improve user experience in 60 GHz large bandwidth scenarios, including improving an average user throughput and energy efficiency of battery-type power supply devices. This requires highspeed and reliable transmission of data, time-frequency, and other services on limited frequency and power resources. Therefore, a high-reliability and high-efficiency channel coding/decoding scheme is required. So far, in the field of channel coding, a low-density parity check (low-density parity check, LDPC) code is one of most mature and widely applied channel coding schemes, and has been widely applied to the communication field. LDPC has performance close to the Shannon limit, and has many advantages. For example, good bit error performance can be obtained without deep interleaving, frame error rate performance is good, an error floor is greatly reduced, decoding is not based on a network, parallel decoding is supported, and a decoding delay is short. Therefore, LDPC has become a standard channel coding scheme for a low-frequency short-range WLAN communication system in the IEEE 802.11n/ac/ax. In addition, the LDPC becomes a mandatory channel coding scheme when a bandwidth of the IEEE 802.11ax is greater than or equal to 40 MHz.

A new next-generation wireless WLAN standard 802.11be of the 802.11ax proposes to introduce a hybrid automatic repeat request (hybrid automatic repeat request, HARQ), to further improve a throughput rate of a system. The HARQ mainly includes storage, retransmission request, and combination and demodulation. When failing to decode data, a receive end saves received data, and requests a transmit end to retransmit data. The receive end combines the retransmitted data and the previously received and saved data, and then decodes the data, thereby achieving a diversity gain, reducing a quantity of retransmission times and a delay, and improving a probability of successful data decoding.

The HARQ may roughly include two types: chase combining (chase combine, CC) and incremental redundancy (incremental redundancy, IR), which may be referred to as a CC-HARQ and an IR-HARQ, respectively.

A HARQ mechanism may be considered as two types: chase combining (chase combine, CC) and incremental redundancy (incremental redundancy, IR-HARQ). In a pure HARQ mechanism, the receive end directly discards data packets that are not correctly received. However, although these data packets that are not correctly received cannot be decoded independently and correctly, the data packets still include a part of wanted information. For CC-HARQ, in a CC process, the data packets that are not correctly received are stored in a memory based on the part of information, and are combined with a retransmitted data packet for decoding. This improves transmission efficiency. In the IR-HARQ mechanism, the transmit end sends an information bit and a part of redundant bits during first transmission, and sends an additional redundant bit during retransmission. If decoding is not successfully performed during first transmission, the transmit end retransmits more redundant bits to reduce a code rate of a channel, to improve a success rate of decoding. If the receive end still cannot successfully perform decoding after the retransmitted redundant bits are added, the transmit end performs retransmission again. As a quantity of retransmissions increases, redundancy bits continuously increases, and the channel coding rate continuously decreases, so that better decoding effect can be achieved.

If the IR HARQ mechanism is introduced to the next-generation standard of the WLAN, an LDPC encoding scheme (rate-compatible LDPC, RC-LDPC) that is compatible with a plurality of rates is required for support, so that a new incremental redundancy bit can be introduced during retransmission.

To facilitate understanding of the solutions of this application, a concept related to an LDPC is first described.

The LDPC is a linear block code, and a check matrix of the LDPC is a sparse matrix, that is, a quantity of zero elements in the check matrix is far greater than a quantity of non-zero elements. In other words, a row weight and a column weight of the check matrix are very small numbers compared with a code length of the LDPC.

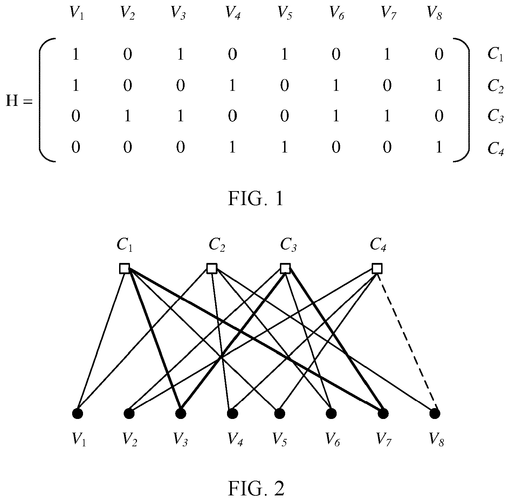

In 1981, Tanner represented an LDPC codeword in a graph. Now, this graph is referred to as a Tanner graph. The Tanner graph is in a one-to-one correspondence with the check matrix, and is formed by two types of nodes. One type of node indicates a codeword symbol, and is referred to as a variable node. The other type of node is a check node, and indicates a check constraint relationship. Each check node indicates a check constraint relationship. The following provides description with reference to FIG. 1 and FIG. 2.

FIG. 1 is a check matrix H of an LDPC. In FIG. 1, {Vᵢ} indicates a variable node set, and {Cᵢ} indicates a check node set. Each row of the check matrix H indicates one check equation, and each column indicates one codeword bit. In FIG. 1, there are eight variable nodes and four check nodes. If a codeword bit is included in a corresponding check equation, a variable node and a check node that are used are connected by using a connection line, to obtain a Tanner graph.

FIG. 2 is a Tanner graph of a check matrix H of an LDPC. As shown in FIG. 2, the Tanner graph indicates the check matrix of the LDPC. For example, for the check matrix H with a size of m rows and n columns, the Tanner graph includes two types of nodes: n variable nodes and m check nodes. The n variable nodes respectively correspond to the n columns of the check matrix H, and the m check nodes respectively correspond to the m rows of the check matrix H. A cycle in a Tanner graph consists of nodes that are connected to each other. A cycle uses one node in the group as a start point and an end point at the same time and passes through each node only once. A length of the cycle is defined as a quantity of connection lines included in the cycle. A girth of a graph may also be referred to as a size of the graph, and is defined as a minimum cycle length in the graph. In FIG. 2, a girth is 6, as shown by a bold connection line in FIG. 2. The variable nodes in the Tanner graph each correspond to one column of the check matrix H, that is, correspond to each codeword bit of the LDPC codeword. Check nodes in the Tanner graph each correspond to one row of the check matrix H, that is, correspond to check bits of the LDPC codeword. Connection between the two types of nodes corresponds to a value of an element in the matrix H. If there is a connection between an i^{th} check node and a j^{th} variable node, it indicates that a value of an element (i, j) in the matrix H is 1. If there is no connection between an i^{th} check node and a j^{th} variable node, a corresponding element is 0. In addition, in the Tanner graph, a cycle (cycle) is a closed cycle formed by a variable node, a check node, and an edge that are connected end-to-end.

As described above, the LDPC code is a linear block code. In the linear block code, a to-be-encoded information sequence is divided into groups in a unit of k bits, and an encoder performs a linear operation on the k information bits to obtain m check bits. Then, the k information bits are combined with the m check bits to obtain a code group whose length is n = k + m. A mapping relationship between the information bits of k bits and the code group whose length is n bits is usually represented by a corresponding check matrix H. An encoding sequence may be correspondingly generated based on the check matrix H, to complete an encoding process. After an encoded codeword is transmitted through a channel, the receive end decodes a received signal accordingly to determine original information bits.

When a code length is long, the check matrix H of the LDPC is very large. Therefore, the check matrix H is usually indicated by blocks. The check matrix H (specifically, an original check matrix) is considered to be generated by using a plurality of submatrices of z × z. Therefore, the check matrix H may be represented by using one mother matrix H_{b}. Each element in the mother matrix corresponds to one submatrix of z × z, and each submatrix may be represented by using a quantity of cyclic shift bits. Storage space required by the check matrix H is greatly reduced. Each check matrix corresponds to one code rate and one code length.

In embodiments of this application, a check matrix in the 802.11ac standard is used, and code lengths 1944, 1296, and 648 are supported. All the three code lengths support code rates 1/2, 2/3, 3/4, and 5/6. The original check matrix H may be obtained based on the mother matrix and an expansion factor z that are provided in the 802.11ac standard.

An LDPC code used in the IEEE 802.11ac and 802.11ax standards is a quasi-cyclic low density parity check (quasi-cyclic low density parity check, QC-LDPC) code. The QC-LDPC code is a type of structured LDPC code. Because of a unique structure of the check matrix of the QC-LDPC code, a simple feedback shift register can be used for encoding, to reduce a complexity of encoding the LDPC code.

In the IEEE 802.11ac and 802.11ax, a total of 12 check matrices are used, which support three code lengths. The three code lengths are 648, 1296, and 1944. Each code length supports four code rates: 1/2, 2/3, 3/4, and 5/6. Check bit parts of the 12 check matrices all have a same structure.

For example, a mother matrix of a check matrix H of an LDPC whose code length is 1944 and whose code rate is 5/6 in the 802.11ac is as follows: $\left[\begin{matrix}13 & 48 & 80 & 66 & 4 & 74 & 7 & 30 & & 76 & 52 & 37 & 60 & - & 49 & - & 73 & 31 & 74 & 73 & 23 & 1 & 0 & - & - \\ 69 & 63 & 74 & 56 & 64 & 77 & 57 & 65 & & 6 & 16 & 51 & - & 64 & - & 64 & 68 & 9 & 48 & 62 & 54 & - & 0 & 0 & - \\ 51 & 15 & 0 & 80 & 24 & 25 & 42 & 54 & & 44 & 71 & 71 & 9 & 67 & 35 & 67 & - & 58 & - & 29 & - & 0 & - & 0 & 0 \\ 16 & 29 & 36 & 41 & 44 & 56 & 59 & 37 & & 50 & 24 & - & 65 & 4 & 65 & 4 & 52 & - & 4 & - & 73 & 1 & - & - & 0\end{matrix}\right]$

It can be learned that a size of the mother matrix is 4 rows and 24 columns. Each element in the mother matrix indicates a z = N/24-order square matrix. "-" in the mother matrix indicates an all-zero square matrix whose size is *z* × *z* . An element i in the mother matrix indicates a cyclic shift value. 0 ≤ i ≤ z - 1, and i is an integer. For example, i = 0 indicates an identity matrix whose size is 81 × 81, and i = 1 indicates a cyclic shift matrix in the following: $\left[\begin{matrix}0 & 1 & 0 & … & 0 \\ 0 & 0 & 1 & … & 0 \\ ⋮ & ⋮ & ⋮ & ⋱ & ⋮ \\ 0 & 0 & 0 & ⋯ & 1 \\ 1 & 0 & 0 & ⋯ & 0\end{matrix}\right]$

When LDPC encoding is performed in a conventional WLAN, a transmit end selects a corresponding check matrix from the foregoing 12 check matrices based on a target code length and a target code rate. The 12 check matrices are different from each other.

If the IR-HARQ mechanism is introduced to the next-generation WLAN standard, a rate-compatible LDPC encoding scheme also needs to be introduced, to obtain a new incremental redundancy bit during retransmission.

The following describes the technical solutions provided in this application.

The technical solutions of this application are mainly applicable to a wireless communication system. The wireless communication system may comply with a 3rd generation partnership project (third generation partnership project, 3GPP) wireless communication standard, or may comply with another wireless communication standard, for example, an IEEE 802 series (for example, 802.11, 802.15, or 802.20) wireless communication standard.

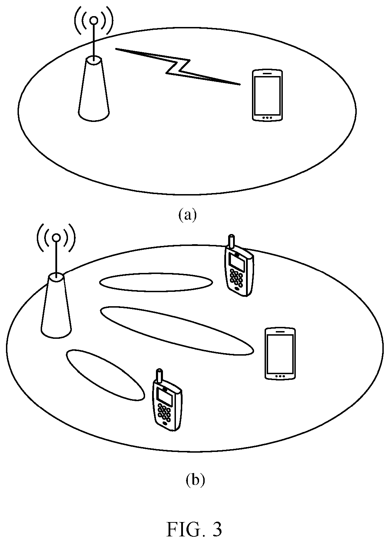

Refer to FIG. 3. (a) and (b) in FIG. 3 are diagrams of system architectures applicable to embodiments of this application. The wireless communication system includes at least one network device and one or more terminal devices. The at least one network device and the one or more terminal devices communicate with each other by using a wireless communication technology. For example, (a) in FIG. 3 shows communication between one network device and a single terminal device. (b) in FIG. 3 shows communication between one network device and a plurality of terminal devices. Optionally, the communication between the network device and the terminal device may further include downlink transmission in which the network device sends a signal to the terminal device and uplink transmission in which the terminal device sends a signal to the network device. This is not limited in this specification.

The technical solutions of this application may be applied to an uplink and downlink data transmission scenario. For example, in uplink transmission, the transmit end in each embodiment is a terminal device, and the receive end is a network device. In downlink transmission, the transmit end is a network device, and the receive end is a terminal device.

A terminal device in embodiments of this application may be user equipment (user equipment, UE), a terminal (terminal), a mobile phone (mobile phone), a tablet computer (tablet computer), a laptop computer (laptop computer), a wearable device (for example, a smartwatch, a smart band, a smart helmet, or smart glasses), and another device having a wireless access capability, for example, a smart car or various Internet of Things (Internet of Things, IoT) devices including various smart home devices (such as a smart meter and a smart home appliance) and smart city devices (such as a security or monitoring device and an intelligent road transportation facility), and a terminal device in a 5G system or a future communication system.

The network device in embodiments of this application may be a base station. The base station is sometimes referred to as a wireless access point (access point, AP), a transmission/reception point (transmission reception point, TRP), or a transmission point (transmission point, TP). Optionally, the base station may be a generation nodeB (generation NodeB, gNB) in a 5th generation (5th generation, 5G) system or an evolved nodeB (evolved NodeB, eNB) in a long term evolution (long term evolution, LTE) system. In addition, base stations may be classified into a macro base station (macro base station) or a micro base station (micro base station) based on different physical forms or transmit powers of the base stations. The micro base station is also sometimes referred to as a small base station or a small cell (small cell). In addition, the network device may alternatively be a network node that forms the gNB or the TRP, for example, a baseband unit (building baseband unit, BBU), a central unit (central unit, CU), or a distributed unit (distributed unit, DU).

This application provides an LDPC-based repetition scheme. Information bits in LDPC codeword bits are repeated, so that repeated information bits can be obtained during retransmission, and a receive end combines these repeated information bits with corresponding information bits transmitted for the first time.

In addition, the LDPC repetition scheme provided in this application may be alternatively used in combination with a puncturing (or puncture) scheme, so that information bits in the LDPC codeword bits can be repeated, puncturing is performed on check bits in the LDPC codeword bits, and the part of information bits and remaining check bits obtained after puncturing are retransmitted, to finally obtain a more flexible HARQ retransmission mechanism. The receive end may combine the bits transmitted for the first time, the part of retransmitted information bits, and incremental redundancy bits at the same time, to obtain a performance gain.

A basic idea of an LDPC repetition scheme based on a confidence criterion provided in this application is: determining a position of a sensitive information bit to be repeated based on a statistical confidence feature, for example, an absolute value of a comparison likelihood rate (likelihood rate, LLR) of iterative decoding. The IR-HARQ requires that bit rates of LDPCs at the receive end be compatible, that is, bits transmitted at a high bit rate are included in bits transmitted at a low bit rate. The retransmitted information bits need to meet this condition. In the IR-HARQ mechanism, a system bit with a low confidence are repeated first, because an error is more likely to occur for a bit with a low confidence, and only system bits carry valid information.

In order to describe a basic principle of the confidence criterion, the sensitivity of a codeword bit is defined first.

First, a fixed signal source is an all-zero signal source. In a noise-free case, iterative calculation for a specific quantity of iterations is performed on an LDPC codeword on which rate matching has not been performed, and after iterative decoding is converged, an absolute value |*LLR*| of an LLR of the iterative decoding is used as a confidence feature, to determine sensitivity of a bit position. A smaller |*LLR*| indicates that a bit position corresponding to |*LLR*| is more sensitive.

It should be noted that, because the LDPC code is a linear code, and sensitivity-based sorting of check bit positions determined by using different signal sources are similar, distribution characteristics of cycles and degrees to which different information bits belong are the same, and puncturing performance is basically the same. Therefore, in the technical solutions of this application, the fixed signal source is an all-zero signal source.

Information bits of an LDPC to be repeated are sorted in ascending (or descending) order of confidences, and a sorting relationship is stored in Table T. Table T is a sensitivity-based sorting table of bit positions.

Optionally, in an example, Table T may be represented by using the following formula (1): $T = \left({t}_{1}, {t}_{2}, ⋯, {t}_{\frac{K}{{R}_{0}} - K}\right)$

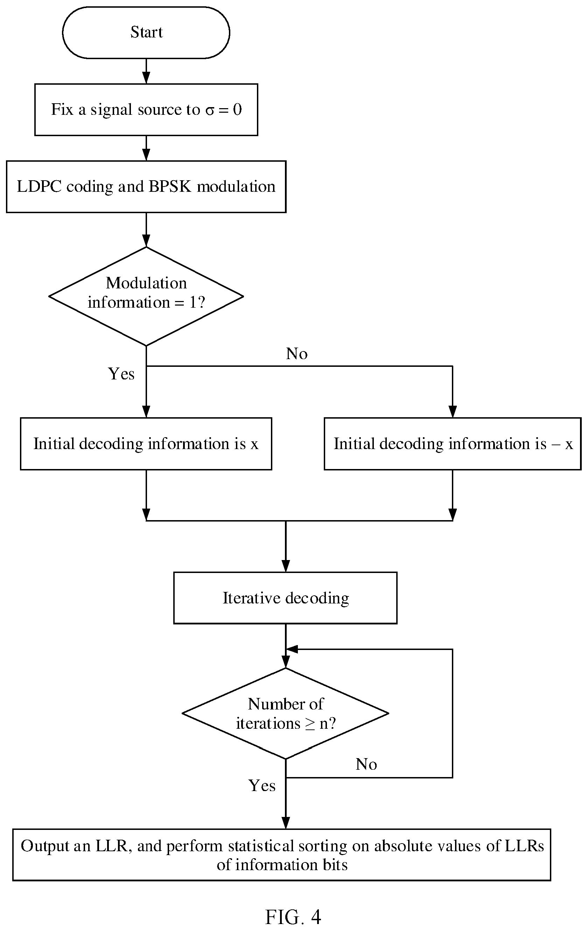

The following describes a process of establishing a sensitivity-based sorting table of bit positions with reference to FIG. 4.

FIG. 4 is a flowchart of establishing a sensitivity-based sorting table of bit positions according to this application. As shown in FIG. 4, in a noise-free environment, an all-zero signal source is fixed, LDPC encoding with a corresponding code rate and code length is performed. Then, modulation such as binary phase shift keying (binary phase shift keying, BPSK) modulation is performed. Initial decoding information is set to a fixed value ± x, and then is sent to an iterative decoder for decoding. After a specific quantity of iterations (for example, n times), an LLR of check bits are output, and absolute values of the LLR are sorted, for example, sorted in ascending order.

Optionally, the iterative decoder may specifically be a log-SPA iterative decoder. SPA indicates a sum-product algorithm (sum-product algorithm), which is a type of LDPC decoding algorithm based on iterative decoding, and belongs to a soft-decision algorithm. When a log-SPA decoding algorithm is used, initial decoding information of an additive white Gaussian noise (additive white Gaussian noise, AWGN) channel is y/ σ ², where y is channel information, and σ ² is a noise variance. When the noise variance is 0, the initial decoding information should be ±∞ . If this is set directly in a computer program, data overflow occurs. Therefore, when a check information is solved, a function shown in formula (2) is used: $φ \left(x\right) = log \frac{{e}^{x} + 1}{{e}^{x} - 1}$

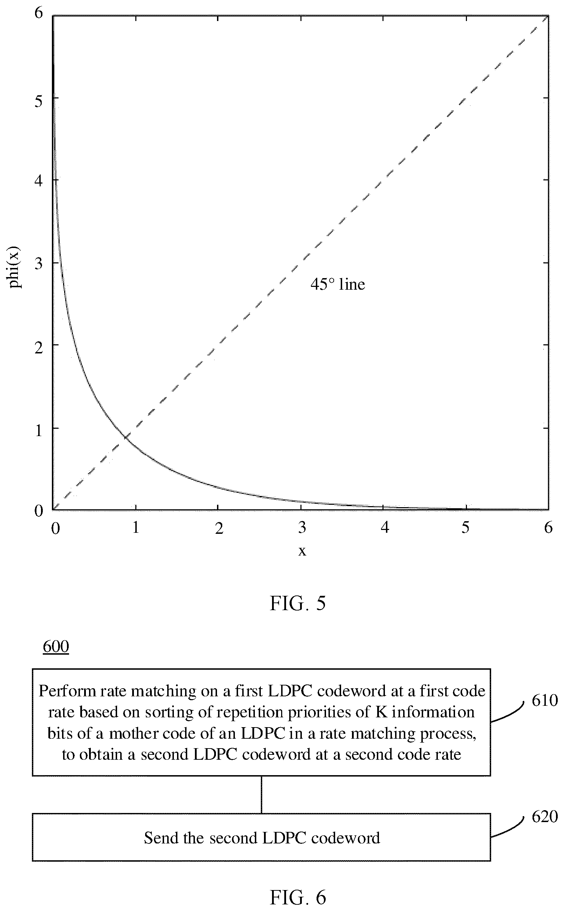

A function property of *φ*(*x*) is shown in FIG. 5. FIG. 5 shows an image of the function *φ*(*x*).

Optionally, during actual decoding, a decoding initial value x may be set to 3, 4, 5, or the like.

Based on the foregoing principle, for a next-generation WLAN system based on an IR-HARQ mechanism, this application provides repetition priority sorting based on LDPCs whose bit rates are 1/2, 2/3, 3/4, and 5/6.

During first transmission, in the IR-HARQ mechanism, an original LDPC codeword may be directly transmitted, or puncturing is first performed on check bits of the original LDPC codeword, and then the punctured codeword is transmitted.

During an i^{th} transmission, a part of information bits are retransmitted in descending order of priorities (in ascending order of confidences), or a part of check bits obtained after puncturing are retransmitted at the same time. A quantity of retransmitted bits is determined based on a new code rate for retransmission or a quantity of channel resources of a channel allocated for retransmission.

FIG. 6 is a schematic flowchart of an LDPC rate matching method according to this application. The methods in embodiments of this application may be performed by a transmit end, or may be performed by a component or a module such as a chip, a processor, or a processing circuit disposed in the transmit end. In the following embodiments, an example in which the method is performed by the transmit end is used for description.

410: The transmit end performs rate matching on a first LDPC codeword at a first code rate based on an order of repetition priorities of K information bits of a mother code of a low-density parity-check LDPC in a rate matching process, to obtain a second LDPC codeword at a second code rate.

In this application, a priority at which an information bit in an LDPC codeword is repeated (or repeatedly sent) in a rate matching process is referred to as a repetition priority.

The order of repetition priorities of the K information bits indicates reliability (or confidences) of the K information bits.

For example, a higher repetition priority of an information bit indicates higher reliability of the information bit. In rate matching, the information bit is repeated first. On the contrary, a lower repetition priority of an information bit indicates lower reliability of the information bit. In rate matching, the information bit is repeated later in the K information bits.

Optionally, the repetition priorities of the K information bits may be sorted in descending order. In this case, an information bit in a front position has a higher repetition priority. Alternatively, the information bits may be sorted in ascending order. In this case, an information bit at a subsequent position has a higher repetition priority.

It should be understood that, in a conventional WLAN, LDPC encoding is performed on the K information bits by using a check matrix corresponding to a target code rate and a target code length, to obtain a mother code of an LDPC whose length is N. In N codeword bits of the mother code, K codeword bits correspond to the K information bits, and remaining (N - K) codeword bits correspond to (N - K) check bits, where both N and M are positive integers, and N > K. For example, the target code rate may be 1/2, 2/3, 3/4, and 5/6 described above, and the target code length may be 1944, 1296, and 648.

Bit rates correspond to different check matrices. Therefore, from a high bit rate to a low bit rate or from a low bit rate to a high bit rate, a bit rate change can be implemented only by selecting different check matrices.

However, in embodiments of this application, because the IR-HARQ mechanism requires compatibility between a high bit rate and a low bit rate, a process from a high bit rate to a low bit rate or from a low bit rate to a high bit rate may also be implemented based on a same check matrix. The process from a high bit rate to a low bit rate or from a low bit rate to a high bit rate is rate matching.

In an embodiment, the first LDPC codeword in step 410 may be the mother code. In this case, the first code rate of the first LDPC codeword is a code rate of the mother code. In other words, LDPC encoding is performed on the K information bits by using the check matrix of the target code length and the target code rate, to obtain the first LDPC codeword. A code length of the first LDPC is the target code length, and the first code rate of the first LDPC codeword is the target code rate. For example, the foregoing check matrix of the LDPC whose code length is 1944 and code rate is 5/6 is used as an example. LDPC encoding is performed on the K information bits by using the check matrix, to obtain the first LDPC codeword whose code length is 1944 and code rate is 5/6.

On this basis, rate matching may be performed on the first LDPC codeword at the first code rate according to the rate matching scheme provided in this application, to obtain the second LDPC codeword at the second code rate.

For example, if the first LDPC codeword at the first code rate is successfully transmitted for the first time, the transmit end may attempt to use a higher code rate. In this case, rate matching is performed on the first LDPC codeword at the first code rate, to obtain the second LDPC codeword at the higher code rate. In other words, the second code rate is higher than the first code rate.

For another example, if the first LDPC codeword at the first code rate is not successfully transmitted for the first time, the transmit end may attempt to reduce the code rate, to increase a probability of successful decoding by the receive end. In this case, the transmit end may perform rate matching on the first LDPC codeword at the first code rate, to obtain the second LDPC codeword at a lower code rate. In other words, the second code rate is lower than the first code rate.

Specifically, if rate matching is performed on the first LDPC codeword based on the repetition priorities of the information bits according to this embodiment of this application, to obtain the second LDPC codeword, a bit rate (namely, the second bit rate) of the second LDPC codeword is lower than a first bit rate of the first LDPC codeword.

In this application, rate matching is performed based on repetition priorities of information bits. Alternatively, in some other examples, the repetition priorities of the information bits and puncturing priorities of the check bits may be used in combination.

It should be noted that the foregoing describes a process of obtaining a repetition priority of an information bit based on sensitivity of a codeword bit. Based on a same principle, reliability (that is, confidences) of the check bits may also be sorted based on sensitivity of the check bits, to obtain the puncturing priorities of the check bits.

Different from the repetition priorities of the information bits, if a check bit is more sensitive, it indicates lower reliability of the check bit. In this case, the check bit is punctured first during rate matching. Therefore, a puncturing priority of the check bit is higher. On the contrary, lower sensitivity of a check bit indicates higher reliability of the check bit, and then a puncturing priority of the check bit is lower during rate matching.

Retransmission is performed to improve a decoding success rate of the receive end, and a check bit with a higher puncturing priority has lower reliability. Therefore, in a retransmission process, the check bit has a lowest priority of being retransmitted by the transmit end. On the contrary, a check bit with a lower puncturing priority has a higher priority of being retransmitted by the transmit end in the retransmission process.

In another embodiment, the first LDPC codeword may be an LDPC codeword obtained through rate matching. For example, the first LDPC codeword may be an LDPC codeword obtained by puncturing the mother code. Alternatively, the first LDPC codeword may be an LDPC codeword obtained by repeating a part of information bits of the mother code. On this basis, the transmit end may perform rate matching on the first LDPC codeword at the first code rate based on the repetition priorities of the information bits, or based on the repetition priorities of the information bits and the puncturing priorities of the check bits, to obtain an expected second code rate.

420: The transmit end sends an LDPC codeword at the second code rate.

Therefore, an order of repetition priorities of information bits according to this application is used for rate matching of the LDPC codeword. Specifically, the transmit end obtains an LDPC codeword at a lower code rate by repeating an information bit, with a higher repetition priority, of an LDPC codeword at a high code rate. Alternatively, the transmit end repeats information bits, with a higher repetition priority, of an LDPC codeword at a high code rate, and punctures a part of check bits, with high puncturing priorities, of the LDPC codeword, to obtain an expected code rate. In this application, a high bit rate is compatible with a low bit rate.

Currently, LDPCs at each code rate (four code rates in total: 1/2, 2/3, 3/4, and 5/6) in the WLAN have three code lengths: 648, 1296, and 1944. Therefore, this application separately provides an order of confidences of corresponding information bits for the four code rates and the three code lengths.

### (1) A code rate R = 1/2, and a code length L = 1944.

A mother matrix (denoted as a matrix 1) of a check matrix of the LDPC code whose code rate is 1/2 and code length is 1944 is first provided as follows: $\left[\begin{matrix}57 & - & - & - & 50 & - & 11 & - & 50 & - & 79 & - & 1 & 0 & - & - & - & - & - & - & - & - & - & - \\ 3 & - & 28 & - & 0 & - & - & - & 55 & 7 & - & - & - & 0 & 0 & - & - & - & - & - & - & - & - & - \\ 30 & - & - & - & 24 & 37 & - & - & 56 & 14 & - & - & - & - & 0 & 0 & - & - & - & - & - & - & - & - \\ 62 & 53 & - & - & 53 & - & - & 3 & 35 & - & - & - & - & - & - & 0 & 0 & - & - & - & - & - & - & - \\ 40 & - & - & 20 & 66 & - & - & 22 & 28 & - & - & - & - & - & - & - & 0 & 0 & - & - & - & - & - & - \\ 0 & - & - & - & 8 & - & 42 & - & 50 & - & - & 8 & - & - & - & - & - & 0 & 0 & - & - & - & - & - \\ 69 & 79 & 79 & - & - & - & 56 & - & 52 & - & - & - & 0 & - & - & - & - & - & 0 & 0 & - & - & - & - \\ 65 & - & - & - & 38 & 42 & - & - & 72 & - & 27 & - & - & - & - & - & - & - & - & 0 & 0 & - & - & - \\ 64 & - & - & - & 14 & 56 & - & - & 30 & - & - & 32 & - & - & - & - & - & - & - & - & 0 & 0 & - & - \\ - & 45 & - & 70 & 0 & - & - & - & 77 & 9 & - & - & - & - & - & - & - & - & - & - & - & 0 & 0 & - \\ 2 & 56 & - & 57 & 35 & - & - & - & - & - & - & 12 & - & - & - & - & - & - & - & - & - & - & 0 & 0 \\ 24 & - & 61 & - & 60 & - & - & 27 & 51 & - & - & 16 & 1 & - & - & - & - & - & - & - & - & - & - & 0\end{matrix}\right]$

As shown above, a size of the matrix 1 is 12 × 24, and each element in the matrix 1 indicates a square matrix of z = 1944/24 = 81-order. "-" indicates an all-zero matrix of 81 × 81. Each element i in the matrix 1 indicates a cyclic permutation matrix of 81 × 81, and i indicates a cyclic shift value. For example, i = 0 indicates an identity matrix with a size of 81 × 81.

Optionally, |*LLR*| of check bits in the mother matrix of the check matrix corresponding to the LDPC whose code rate is 1/2 and whose code length is 1944 and sorting of reliability of the check bits may be shown in Table 1.

**Table 1**

| | | | | | | |
|---|---|---|---|---|---|---|
| Reliability sorting | 19 (2) | 20 (2) | 18 (2) | 21 (2) | 17 (2) | 22 (2) |
| \|*LLR*\| | 26.9747 | 27.1948 | 27.3161 | 27.9524 | 28.1107 | 29.1414 |
| Reliability sorting | 16 (2) | 23 (2) | 15 (2) | 24 (2) | 14 (2) | 13 (3) |
| \|*LLR*\| | 29.2333 | 30.6309 | 30.6696 | 32.3636 | 32.5114 | 32.5925 |

In Table 1, a (b) indicates an a^{th} column of the mother matrix, and a column weight of the a^{th} column is b (that is, a quantity of 1s in the column is b).

As shown in Table 1, because a smaller confidence indicates a higher probability of an error and less valid information that can be provided for another system variable node, a check bit with a smaller confidence is punctured first. In addition, check bits obtained after puncturing can further ensure recoverability of the system variable node, especially when there are a large quantity of punctured bits.

It should be understood that, in embodiments of this application, an order of reliability of columns, in the mother matrix, corresponding to information bits is consistent with an order of repetition priorities of the columns in a rate matching process. That is, the descending order of reliability is the descending order of repetition priorities.

Table 2 shows an order of repetition priorities of information bits provided in this application.

**Table 2**

| | | | | | | |
|---|---|---|---|---|---|---|
| Reliability sorting | 10 (3) | 6 (3) | 8 (3) | 11 (3) | 4 (3) | 3 (3) |
| \|*LLR*\| | 35.1049 | 35.3955 | 35.3983 | 35.4292 | 35.4818 | 35.5749 |
| Reliability sorting | 12 (3) | 7 (3) | 2 (4) | 5 (11) | 9 (11) | 1 (11) |
| \|*LLR*\| | 35.6812 | 35.8946 | 47.0243 | 126.4571 | 126.7682 | 126.7955 |

In Table 2, a (b) indicates an a^{th} column of the mother matrix, and a column weight of the a^{th} column is b. As shown in Table 2, an information bit with a smaller confidence has a higher repetition priority.

This application provides only sorting of repetition priorities of information bits. Therefore, Table 2 provides sorting of the first column to the twelfth column of the matrix 1, because the first column to the twelfth column correspond to an information (or in other words, a system) part of the check matrix. Codeword bits corresponding to these columns are all original information bits.

According to the correspondence between the original check matrix and the mother matrix described above, for a mother matrix whose size is p × q, each element of the mother matrix corresponds to a square matrix whose order is z = N/q, and each column in the mother matrix corresponds to z codeword bits of the original check matrix. The repetition priority of the information bit is given by using a column of the mother matrix. Therefore, repetition priorities of the z codeword bits, corresponding to each column of the mother matrix, in the original check matrix are the same.

For example, a size of a mother matrix corresponding to an LDPC whose code rate R=1/2 and code length N=1944 is 12 × 24, and each element in the mother matrix corresponds to a square matrix with z = 1944/24 = 81. Therefore, any column of the mother matrix corresponds to 81 codeword bits of an original check matrix. The tenth column with the highest reliability in Table 2 is used as an example. Repetition priorities of 81 codeword bits in the original check matrix corresponding to the tenth column are the same.

As shown in Table 2, for the check matrix of the LDPC whose code rate is 1/2 and code length is 1944, repetition priorities of columns, corresponding to information bits, in the mother matrix of the check matrix of the LDPC in rate matching may be sorted in descending order as the following sorting 1:
Sorting 1: 10, 6, 8, 11, 4, 3, 12, 7, 2, 5, 9, and 1.

Each element a in the sorting 1 indicates an a^{th} column of the mother matrix of the check matrix. In addition, indexes of columns in the mother matrix start from 1. For example, for a mother matrix with a size of 12 × 24, a value range of an index of a column of the mother matrix is [1, 24].

Optionally, in embodiments of this application, indexes of columns of the mother matrix may alternatively start from 0. This is not limited. Whether the indexes start from 0 or the indexes start from 1, sorting of repetition priorities of columns, corresponding to information bits, in the mother matrix indicated by the index is the same in essence.

In addition, it should be understood that columns of the mother matrix include two parts, one part corresponds to information bits, and the other part corresponds to check bits. For example, the size of the mother matrix corresponding to the LDPC whose code rate R = 1/2 and code length N = 1944 is 12 × 24, the first column to the twelfth column of the 24 columns correspond to information bits, and the thirteenth column to the twenty-fourth column correspond to check bits. Therefore, because this application mainly relates to sorting of repetition priorities of information bits, the "columns, in the mother matrix, corresponding to the information bits" described in embodiments means all columns other than a check part of the mother matrix. For example, in the mother matrix corresponding to an LDPC whose code rate is R = 1/2 and code length is N = 1944, "columns corresponding to information bits" are the first column to the twelfth column of the mother matrix. This is similar in the following embodiments, and details are not described again.

If each column of the mother matrix corresponds to z codeword bits of the original check matrix, in a rate matching process, an information bit may be selected and repeated, according to the following rule, based on a quantity L of information bits that need to be repeated.

In a possible case, if L < z, the transmit end selects L information bits from z information bits corresponding to a column with a highest repetition priority in the mother matrix to repeat.

Specifically, because z information bits, in the original check matrix, corresponding to each column in the mother matrix have a same repetition priority, the transmit end may randomly select the L information bits from the z information bits corresponding to the column with the highest repetition priority to repeat. For example, the transmit end selects the L information bits in a back-to-front, front-to-back, or random selection manner.

Table 2 is used as an example. If a quantity of information bits that need to be repeated is L = 50, and L < z = 81, the transmit end only needs to randomly select 50 information bits from 81 information bits, in the original matrix, corresponding to the tenth column of the mother matrix.

In another possible case, if L = m × z, and m is a positive integer, the transmit end selects, from the mother matrix, mz information bits that are in the original check matrix and that correspond to m columns with highest repetition priorities, to perform repetition.

Because the quantity of information bits that need to be repeated is exactly equal to the quantity of information bits that are in the original check matrix and that correspond to the m columns in the mother matrix, the transmit end selects, in descending order of repetition priorities, the m × z information bits that are in the original check matrix and that correspond to the m columns with the highest repetition priorities to repeat.

Table 2 is used as an example. If a quantity of information bits that need to be repeated is L = 81, and L = z, the transmit end repeats 81 information bits, in the original matrix, corresponding to the tenth column of the mother matrix. If a quantity of information bits that need to be repeated is L = 162, and L = 2 × z, the transmit end repeats 81 information bits that are in the original check matrix and that correspond to the tenth column of the mother matrix, and 81 information bits that are in the original check matrix and that correspond to the sixth column of the mother matrix. If a quantity of information bits that need to be repeated is L = 4 × z, the transmit end repeats a total of 4 × 81 information bits that correspond to the tenth column, the sixth column, the eighth column, and the eleventh column of the mother matrix and that are in the original matrix. Details are not described one by one.

In yet another possible case, if (m - 1) × z < L < m × z, L is an integer, m > 1, and m is an integer, the transmit end selects, in descending order of repetition priorities from the mother matrix, (m - 1) × z information bits, in the original check matrix, corresponding to first (m - 1) columns with higher repetition priorities, and p information bits in z information bits, in the original check matrix, corresponding to an m^{th} column to repeat, where L = (m - 1) × z + p, p ≥ 1, and p is an integer.

Table 2 is used as an example. For example, if a quantity of information bits that need to be repeated is L = 100, z < L < 2 × z, that is, 81 < L < 162, the transmit end selects 81 information bits, in the original check matrix, corresponding to the tenth column of the mother matrix, and (100 - 81) information bits in 81 information bits that are in the original check matrix and that correspond to the sixth column of the mother matrix to repeat. 19 information bits may be randomly selected from the 81 information bits, in the original check matrix, corresponding to the sixth column of the mother matrix, because repetition priorities of the 81 information bits, in the original check matrix, corresponding to the sixth column of the mother matrix are the same.

For another example, if a quantity of information bits that need to be repeated is L = 170, 2 × z < L< 3 × z, that is, 2 × 81 < L < 3 × 81, the transmit end selects 81 information bits that are in the original check matrix and that correspond to the tenth column of the mother matrix, 81 information bits that are in the original check matrix and that correspond to the sixth column of the mother matrix, and (170 - 2 × 81) information bits in 81 information bits that are in the original check matrix and that correspond to the eighth column of the mother matrix to repeat. Similarly, because z information bits in the original check matrix corresponding to each column of the mother matrix have a same repetition priority, the transmit end only needs to randomly select eight information bits from the 81 information bits, in the original check matrix, corresponding to the eighth column of the mother matrix.

Alternatively, in the foregoing cases, a set including information bits repeated by the transmit end may be referred to as a first information bit set. In other words, the transmit end repeats information bits in the first information bit set of the LDPC codeword based on the quantity L of bits that need to be repeated. The first information bit set includes L information bits. A repetition priority of an information bit with a lowest repetition priority in the L information bits is higher than or equal to a repetition priority of a remaining information bit in all information bits of the LDPC codeword other than the L information bits in the first information bit set.

Table 2 is used as an example. If L = 50, 50 information bits are randomly selected from 81 information bits, in the original matrix, corresponding to the tenth column of the mother matrix to form the first information bit set. If L = 81, 81 information bits, in the original matrix, corresponding to the tenth column of the mother matrix form the first information bit set. If L = 162, 81 information bits that are in the original matrix and that correspond to the tenth column of the mother matrix, and 81 information bits that are in the original check matrix and that correspond to the sixth column of the mother matrix form the first information bit set. If L = 170, 81 information bits that are in the original check matrix and that correspond to the tenth column of the mother matrix, 81 information bits that are in the original check matrix and that correspond to the sixth column of the mother matrix, and any eight information bits in the 81 information bits that are in the original check matrix and that correspond to the eighth column of the mother matrix form the first information bit set.

Table 3 shows a comparison between a repetition scheme based on a confidence criterion provided in this application and a repetition scheme in the 802.11ac standard.

**Table 3**

| | Two columns are repeated | Five columns are repeated | Eight columns are repeated | 10 columns are repeated |
|---|---|---|---|---|
| Repetition scheme based on a confidence criterion | 12 and 14 | 12, 14, 15, 17, and 19 | 12, 14, 15, 17, 19, 13, 20, and 11 | 12, 14, 15, 17, 19, 13, 20, 11, 16, and 18 |
| Repetition scheme in the 802.11ac standard | 1 and 2 | 1, 2, 3, 4, and 5 | 1, 2, 3, 4, 5, 6, 7, and 8 | 1, 2, 3,4, 5, 6, 7, 8, 9, and 10 |

As shown in Table 3, that quantities of information bits that need to be repeated are 2 × 81, 5 × 81, 8 × 81, and 10 × 81 is used as an example. Table 3 lists column indexes of columns, in the mother matrix, corresponding to preferentially repeated information bits. For comparison, repetition priorities in the 802.11ac are from front to back.

In addition, it can be further found from Table 3 that, in the technical solutions of this application, for LDPC codes with specific code lengths, a repetition scheme of an LDPC at a low code rate is compatible with a repetition scheme of an LDPC at a high code rate. In other words, repetition positions of information bits of the LDPC at the low bit rate include repetition positions of information bits of the LDPC at the high bit rate.

For example, when the repetition quantity is 2 × 81 (that is, two columns of the mother matrix), an index set of columns of the mother matrix corresponding to repetition positions of the information bits of the LDPC is {12, 14}.

When the repetition quantity is 5 × 81 (that is, five columns of the mother matrix), an index set of columns of the mother matrix corresponding to repetition locations of the information bits of the LDPC is {12, 14, 15, 17, 19}, where the index set includes the twelfth column and the fourteenth column of the mother matrix.

When the repetition quantity is 8 × 81 (that is, eight columns of the mother matrix), an index set of columns of the mother matrix corresponding to repetition positions of the information bits of the LDPC is {12, 14, 15, 17, 19, 13, 20, 11}. The index set includes not only a case in which the twelfth column and the fourteenth column of the mother matrix, that is, two columns are repeated, but also a case in which the twelfth column, the fourteenth column, the fifteenth column, the seventeenth column, and the nineteenth column of the mother matrix, that is, five columns are repeated.

It may be learned from a rate matching principle that a larger quantity of repeated information bits indicates a higher code rate of the LDPC code. Therefore, in the repetition scheme of this application, a high bit rate is compatible with a low bit rate. In other words, a new repetition position is added to a repetition position of an LDPC codeword at a low code rate, to obtain an LDPC codeword at a higher code rate.

### (2) A code rate R = 1/2, and a code length L = 1296.

A mother matrix (denoted as a matrix 2) of a check matrix of the LDPC code whose code rate is 1/2 and code length is 1296 is provided as follows: $\left[\begin{matrix}40 & - & - & - & 22 & - & 49 & 23 & 43 & - & - & - & 1 & 0 & - & - & - & - & - & - & - & - & - & - \\ 50 & 1 & - & - & 48 & 35 & - & - & 13 & - & 30 & - & - & 0 & 0 & - & - & - & - & - & - & - & - & - \\ 39 & 50 & - & - & 4 & - & 2 & - & - & - & - & 49 & - & - & 0 & 0 & - & - & - & - & - & - & - & - \\ 33 & - & - & 38 & 37 & - & - & 4 & 1 & - & - & - & - & - & - & 0 & 0 & - & - & - & - & - & - & - \\ 45 & - & - & - & 0 & 22 & - & - & 20 & 42 & - & - & - & - & - & - & 0 & 0 & - & - & - & - & - & - \\ 51 & - & - & 48 & 35 & - & - & - & 44 & - & 18 & - & - & - & - & - & - & 0 & 0 & - & - & - & - & - \\ 47 & 11 & - & - & - & 17 & - & - & 51 & - & - & - & 0 & - & - & - & - & - & 0 & 0 & - & - & - & - \\ 5 & - & 25 & - & 6 & - & 45 & - & 13 & 40 & - & - & - & - & - & - & - & - & - & 0 & 0 & - & - & - \\ 33 & - & - & 34 & 24 & - & - & - & 23 & - & - & 46 & - & - & - & - & - & - & - & - & 0 & 0 & - & - \\ 1 & - & 27 & - & 1 & - & - & - & 38 & - & 44 & - & - & - & - & - & - & - & - & - & - & 0 & 0 & - \\ - & 18 & - & - & 23 & - & - & 8 & 0 & 35 & - & - & - & - & - & - & - & - & - & - & - & - & 0 & 0 \\ 49 & - & 17 & - & 30 & - & - & - & 34 & - & - & 19 & 1 & - & - & - & - & - & - & - & - & - & - & 0\end{matrix}\right]$

As shown above, a size of the matrix 2 is 12 × 24, and each element in the matrix 2 indicates a square matrix of z = 1296/24 = 54-order. "-" indicates an all-zero matrix of 54 × 54. Each element i in the matrix 2 indicates a circulant permutation matrix of 54 × 54, and i indicates a cyclic shift value. For example, i = 0 indicates an identity matrix whose size is 54 × 54.

Table 4 shows sorting of repetition priorities of information bits of an LDPC whose code rate is 1/2 and code length is 1296 in this application.

**Table 4**

| | | | | | | |
|---|---|---|---|---|---|---|
| Reliability sorting | 8 (3) | 12 (3) | 7 (3) | 3 (3) | 11 (3) | 10 (3) |
| \|*LLR*\| | 39.2121 | 39.3214 | 39.7775 | 39.7809 | 40.3593 | 40.5239 |
| Reliability sorting | 4 (3) | 6 (3) | 2 (4) | 5 (11) | 9 (11) | 1 (11) |
| \|*LLR*\| | 40.9689 | 41.0671 | 52.9074 | 143.0869 | 144.3379 | 144.4487 |

In Table 4, a (b) indicates an a^{th} column of the mother matrix, and a column weight of the a^{th} column is b.

This application provides only sorting of repetition priorities of information bits. Therefore, Table 4 provides sorting of the first column to the twelfth column of the matrix 2, because the first column to the twelfth column correspond to an information (or in other words, a system) part of the matrix. Codeword bits corresponding to these columns are all original information bits.

Because the matrix 2 gives a mother matrix, each column corresponds to 54 codeword bits of the original check matrix. Each column in the mother matrix corresponds to z information bits of the original check matrix, and repetition priorities of the z codeword bits are the same. The eighth column with the highest repetition priority in Table 4 is used as an example. To be specific, 54 information bits, in the original check matrix, corresponding to the eighth column of the mother matrix have a same repetition priority.

As shown in Table 4, for the check matrix of the LDPC whose code rate is 1/2 and code length is 1296, repetition priorities of columns, corresponding to information bits, in the mother matrix of the check matrix of the LDPC in rate matching may be sorted in descending order as the following sorting 2:
Sorting 2: 8, 12, 7, 3, 11, 10, 4, 6, 2, 5, 9, and 1.

Each element a in the sorting 2 indicates an a^{th} column of the mother matrix of the check matrix. In addition, indexes of columns in the mother matrix start from 1.

### (3) A code rate R = 1/2, and a code length L = 648.

A mother matrix (denoted as a matrix 3) of a check matrix of the LDPC code whose code rate is 1/2 and code length is 648 is provided as follows: $\left[\begin{matrix}0 & - & - & - & 0 & 0 & - & - & 0 & - & - & 0 & 1 & 0 & - & - & - & - & - & - & - & - & - & - \\ 22 & 0 & - & - & 17 & - & 0 & 0 & 12 & - & - & - & - & 0 & 0 & - & - & - & - & - & - & - & - & - \\ 6 & - & 0 & - & 10 & - & - & - & 24 & - & 0 & - & - & - & 0 & 0 & - & - & - & - & - & - & - & - \\ 2 & - & - & 0 & 20 & - & - & - & 25 & 0 & - & - & - & - & - & 0 & 0 & - & - & - & - & - & - & - \\ 23 & - & - & - & 3 & - & - & - & 0 & - & 9 & 11 & - & - & - & - & 0 & 0 & - & - & - & - & - & - \\ 24 & - & 23 & 1 & 17 & - & 3 & - & 10 & - & - & - & - & - & - & - & - & 0 & 0 & - & - & - & - & - \\ 25 & - & - & - & 8 & - & - & - & 7 & 18 & - & - & 0 & - & - & - & - & - & 0 & 0 & - & - & - & - \\ 13 & 24 & - & - & 0 & - & 8 & - & 6 & - & - & - & - & - & - & - & - & - & - & 0 & 0 & - & - & - \\ 7 & 20 & - & 16 & 22 & 10 & - & - & 23 & - & - & - & - & - & - & - & - & - & - & - & 0 & 0 & - & - \\ 11 & - & - & - & 19 & - & - & - & 13 & - & 3 & 17 & - & - & - & - & - & - & - & - & - & 0 & 0 & - \\ 25 & - & 8 & - & 23 & 18 & - & 14 & 9 & - & - & - & - & - & - & - & - & - & - & - & - & - & 0 & 0 \\ 3 & - & - & - & 16 & - & - & 2 & 25 & 5 & - & - & 1 & - & - & - & - & - & - & - & - & - & - & 0\end{matrix}\right]$

As shown above, a size of the matrix 3 is 12 × 24, and each element in the matrix 3 indicates a square matrix of z = 648/24 = 27-order. "-" indicates an all-zero matrix of 27 × 27. Each element i in the matrix 3 indicates a circulant permutation matrix of 27 × 27, and i indicates a cyclic shift value. For example, i = 0 indicates an identity matrix whose size is 27 × 27.

Table 5 shows an order of repetition priorities of information bits of an LDPC whose code rate is 1/2 and code length is 648 in this application.

**Table 5**

| | | | | | | |
|---|---|---|---|---|---|---|
| Reliability sorting | 8 (3) | 6 (3) | 12 (3) | 11 (3) | 2 (3) | 3 (3) |
| \|*LLR*\| | 46.8189 | 48.0339 | 49.6489 | 50.3947 | 50.6030 | 50.0061 |
| Reliability sorting | 10 (3) | 7 (3) | 4 (3) | 1 (12) | 5 (12) | 9 (12) |
| \|*LLR*\| | 51.5432 | 52.8294 | 53.0404 | 199.0153 | 199.0153 | 199.0153 |

In Table 5, a (b) indicates an a^{th} column of the mother matrix, and a column weight of the a^{th} column is b. In addition, Table 5 provides sorting of the first column to the twelfth column of the matrix 3, because the first column to the twelfth column correspond to an information (or in other words, a system) part of the matrix. Codeword bits corresponding to these columns are all original information bits.

Because the matrix 3 gives a mother matrix, each column corresponds to 27 codeword bits of the original check matrix. Each column in the mother matrix corresponds to z information bits of the original check matrix, and repetition priorities of the z codeword bits are the same. The eighth column with the highest repetition priority in Table 5 is used as an example. To be specific, 27 information bits, in the original check matrix, corresponding to the eighth column of the mother matrix have a same repetition priority.

As shown in Table 5, for the check matrix of the LDPC whose code rate is 1/2 and code length is 648, repetition priorities of columns, corresponding to information bits, in the mother matrix of the check matrix of the LDPC in rate matching may be sorted in descending order as the following sorting 3:
Sorting 3: 8, 6, 12, 11, 2, 3, 10, 7, 4, 1, 5, and 9.

Each element a in the sorting 3 indicates an a^{th} column of the mother matrix of the check matrix. In addition, indexes of columns in the mother matrix start from 1.

(4) A code rate R = 2/3, and a code length L = 1944. A mother matrix (denoted as a matrix 4) of a check matrix of the LDPC whose code rate is 1/2 and code length is 648 is provided as follows: $\left[\begin{matrix}61 & 75 & 4 & 63 & 56 & - & - & - & - & - & - & 8 & - & 2 & 17 & 25 & 1 & 0 & - & - & - & - & - & - \\ 56 & 74 & 77 & 20 & - & - & - & 64 & 24 & 4 & 67 & - & 7 & - & - & - & - & 0 & 0 & - & - & - & - & - \\ 28 & 21 & 68 & 10 & 7 & 14 & 65 & - & - & - & 23 & - & - & - & 75 & - & - & - & 0 & 0 & - & - & - & - \\ 48 & 38 & 43 & 78 & 76 & - & - & - & - & 5 & 36 & - & 15 & 72 & - & - & - & - & - & 0 & 0 & - & - & - \\ 40 & 2 & 53 & 25 & - & 52 & 62 & - & 20 & - & - & 44 & - & - & - & - & 0 & - & - & - & 0 & 0 & - & - \\ 69 & 23 & 64 & 10 & 22 & - & 21 & - & - & - & - & - & 68 & 23 & 29 & - & - & - & - & - & - & 0 & 0 & - \\ 12 & 0 & 68 & 20 & 55 & 61 & - & 40 & - & - & - & 52 & - & - & - & 44 & - & - & - & - & - & - & 0 & 0 \\ 58 & 8 & 34 & 64 & 78 & - & - & 11 & 78 & 24 & - & - & - & - & - & 58 & 1 & - & - & - & - & - & - & 0\end{matrix}\right]$

As shown above, a size of the matrix 4 is 8 × 24, and each element in the matrix 4 indicates a square matrix of z = 1944/24 = 81-order. "-" indicates an all-zero matrix of 81 × 81. Each element i in the matrix 4 indicates a circulant permutation matrix of 81 × 81, and i indicates a cyclic shift value. For example, i = 0 indicates an identity matrix whose size is 81 × 81.

Table 6 shows sorting of repetition priorities of information bits of an LDPC whose code rate is 2/3 and code length is 1944 in this application.

**Table 6**

| | | | | | | | | |
|---|---|---|---|---|---|---|---|---|
| Reliability sorting | 16 (3) | 8 (3) | 15 (3) | 12 (3) | 9 (3) | 10 (3) | 14 (3) | 6 (3) |
| \|*LLR*\| | 51.8303 | 52.7906 | 55.7835 | 55.9381 | 55.9510 | 56.0615 | 57.4838 | 58.3637 |
| Reliability sorting | 13 (3) | 11 (3) | 7 (3) | 5 (6) | 1 (8) | 2 (8) | 3 (8) | 4 (8) |
| \|*LLR*\| | 58.4436 | 58.5789 | 59.7989 | 110.0576 | 147.9562 | 147.9562 | 147.9562 | 147.9562 |

In Table 6, a (b) indicates an a^{th} column of the mother matrix, and a column weight of the a^{th} column is b. As shown in Table 6, an information bit with a smaller confidence has a higher repetition priority.

In addition, Table 6 provides sorting of the first column to the sixteenth column of the matrix 4, because the first column to the sixteenth column correspond to an information (or in other words, a system) part of the matrix. Codeword bits corresponding to these columns are all original information bits.

Because the matrix 4 gives a mother matrix, each column corresponds to 81 codeword bits of the original check matrix. Each column in the mother matrix corresponds to z information bits of the original check matrix, and repetition priorities of the z codeword bits are the same. The sixteenth column with the highest repetition priority in Table 6 is used as an example. To be specific, 81 information bits, in the original check matrix, corresponding to the sixteenth column of the mother matrix have a same repetition priority.

As shown in Table 6, for the check matrix of the LDPC whose code rate is 2/3 and code length is 1944, repetition priorities of columns, corresponding to information bits, in the mother matrix of the check matrix of the LDPC in rate matching may be sorted in descending order as the following sorting 4:
Sorting 4: 16, 8, 15, 12, 9, 10, 14, 6, 13, 11, 7, 5, 1, 2, 3, and 4.

Each element a in the sorting 4 indicates an a^{th} column of the mother matrix of the check matrix. In addition, indexes of columns in the mother matrix start from 1.

### (5) A code rate R = 2/3, and a code length L = 1296.

A mother matrix (denoted as a matrix 5) of a check matrix of the LDPC code whose code rate is 2/3 and code length is 1296 is provided as follows: $\left[\begin{matrix}39 & 31 & 22 & 43 & - & 40 & 4 & - & 11 & - & - & 50 & - & - & - & 6 & 1 & 0 & - & - & - & - & - & - \\ 25 & 52 & 41 & 2 & 6 & - & 14 & - & 34 & - & - & - & 24 & - & 37 & - & - & 0 & 0 & - & - & - & - & - \\ 43 & 31 & 39 & 0 & 21 & - & 28 & - & - & 2 & - & - & 7 & - & 17 & - & - & - & 0 & 0 & - & - & - & - \\ 20 & 33 & 48 & - & 4 & 13 & - & 26 & - & - & 22 & - & - & 46 & 42 & - & - & - & - & 0 & 0 & - & - & - \\ 45 & 7 & 18 & 51 & 12 & 25 & - & - & - & 50 & - & - & 5 & - & - & - & 0 & - & - & - & 0 & 0 & - & - \\ 35 & 40 & 32 & 16 & 5 & - & - & 18 & - & - & 43 & 51 & - & 32 & - & - & - & - & - & - & - & 0 & 0 & - \\ 9 & 24 & 13 & 22 & 28 & - & - & 37 & - & - & 25 & - & - & 52 & - & 13 & - & - & - & - & - & - & 0 & 0 \\ 32 & 22 & 4 & 21 & 16 & - & - & - & 27 & 28 & - & 38 & - & - & - & 8 & 1 & - & - & - & - & - & - & 0\end{matrix}\right]$

As shown above, a size of the matrix 5 is 8 × 24, and each element in the matrix 5 indicates a square matrix of z = 1296/24 = 54-order. "-" indicates an all-zero matrix of 54 × 54. Each element i in the matrix 5 indicates a circulant permutation matrix of 54 × 54, and i indicates a cyclic shift value. For example, i = 0 indicates an identity matrix whose size is 54 × 54.

Table 7 shows sorting of repetition priorities of information bits of an LDPC whose code rate is 2/3 and code length is 1296 in this application.

**Table 7**

| | | | | | | | | |
|---|---|---|---|---|---|---|---|---|
| Reliability sorting | 16 (3) | 9 (3) | 12 (3) | 7 (3) | 10 (3) | 8 (3) | 11 (3) | 14 (3) |
| \|*LLR*\| | 51.6235 | 51.7664 | 53.0464 | 54.2856 | 57.1662 | 58.0598 | 58.0598 | 58.0598 |
| Reliability sorting | 13 (3) | 15 (3) | 6 (3) | 4 (7) | 5 (7) | 1 (8) | 2 (8) | 3 (8) |
| \|*LLR*\| | 58.2351 | 58.3730 | 58.9266 | 126.8313 | 130.9186 | 147.3210 | 147.3210 | 147.3210 |

In Table 7, a (b) indicates an a^{th} column of the mother matrix, and a column weight of the a^{th} column is b. Table 7 provides sorting of the first column to the sixteenth column of the matrix 5, because the first column to the sixteenth column correspond to an information (or in other words, a system) part of the check matrix. Codeword bits corresponding to these columns are all original information bits.

Because the matrix 5 gives a mother matrix, each column corresponds to 54 codeword bits of the original check matrix. Each column in the mother matrix corresponds to z information bits of the original check matrix, and repetition priorities of the z codeword bits are the same. The sixteenth column with the highest repetition priority in Table 7 is used as an example. 54 information bits, in the original check matrix, corresponding to the sixteenth column of the mother matrix have a same repetition priority.

As shown in Table 7, for the check matrix of the LDPC whose code rate is 2/3 and code length is 1296, repetition priorities of columns, corresponding to information bits, in the mother matrix of the check matrix of the LDPC in rate matching may be sorted in descending order as the following sorting 5:
Sorting 5: 16, 9, 12, 7, 10, 8, 11, 14, 13, 15, 6, 4, 5, 1, 2, and 3.

Each element a in the sorting 5 indicates an a^{th} column of the mother matrix of the check matrix. In addition, indexes of columns in the mother matrix start from 1.

### (6) A code rate R = 2/3, and a code length L = 648.

A mother matrix (denoted as a matrix 6) of a check matrix of the LDPC code whose code rate is 2/3 and code length is 648 is provided as follows: $\left[\begin{matrix}25 & 26 & 14 & - & 20 & - & 2 & - & 4 & - & - & 8 & - & 16 & - & 18 & 1 & 0 & - & - & - & - & - & - \\ 10 & 9 & 15 & 11 & - & 0 & - & 1 & - & - & 18 & - & 8 & - & 10 & - & - & 0 & 0 & - & - & - & - & - \\ 16 & 2 & 20 & 26 & 21 & - & 6 & - & 1 & 26 & - & 7 & - & - & - & - & - & - & 0 & 0 & - & - & - & - \\ 10 & 13 & 5 & 0 & - & 3 & - & 7 & - & - & 26 & - & - & 13 & 21 & 16 & - & - & - & 0 & 0 & - & - & - \\ 23 & 14 & 24 & - & 12 & - & 19 & - & 17 & - & - & - & 20 & - & - & - & 0 & - & - & - & 0 & 0 & - & - \\ 6 & 22 & 9 & 20 & - & 25 & - & 17 & - & 8 & - & 14 & - & 18 & - & - & - & - & - & - & - & 0 & 0 & - \\ 14 & 23 & 21 & 11 & 20 & - & 24 & - & 18 & - & 19 & - & - & - & - & 22 & - & - & - & - & - & - & 0 & 0 \\ 17 & 11 & 11 & 20 & - & 21 & - & 26 & - & 3 & - & - & 18 & - & 26 & - & 1 & - & - & - & - & - & - & 0\end{matrix}\right]$

As shown above, a size of the matrix 6 is 8 × 24, and each element in the matrix 6 indicates a square matrix of z = 648/24 = 27-order. "-" indicates an all-zero matrix of 27 × 27. Each element i in the matrix 6 indicates a circulant permutation matrix of 27 × 27, and i indicates a cyclic shift value. For example, i = 0 indicates an identity matrix whose size is 27 × 27.

Table 8 shows sorting of repetition priorities of information bits of an LDPC whose code rate is 2/3 and code length is 648 in this application.

**Table 8**

| | | | | | | | | |
|---|---|---|---|---|---|---|---|---|
| Reliability sorting | 16 (3) | 9 (3) | 12 (3) | 7 (3) | 10 (3) | 8 (3) | 11 (3) | 14 (3) |
| \|*LLR*\| | 51.6235 | 51.7664 | 53.0464 | 54.2856 | 57.1662 | 58.0598 | 58.0598 | 58.0598 |
| Reliability sorting | 13 (3) | 15 (3) | 6 (3) | 4 (7) | 5 (7) | 1 (8) | 2 (8) | 3 (8) |
| \|*LLR*\| | 58.2351 | 58.3730 | 58.9266 | 126.8313 | 130.9186 | 147.3210 | 147.3210 | 147.3210 |

In Table 8, a (b) indicates an a^{th} column of the mother matrix, and a column weight of the a^{th} column is b.

In addition, each column in the mother matrix corresponds to z information bits of the original check matrix, and repetition priorities of the z codeword bits are the same. Because the matrix 6 gives a mother matrix, each column corresponds to 27 codeword bits of the original check matrix. The sixteenth column with the highest repetition priority in Table 7 is used as an example. 27 information bits, in the original check matrix, corresponding to the sixteenth column of the mother matrix have a same repetition priority.

As shown in Table 8, for the check matrix of the LDPC whose code rate is 2/3 and code length is 648, repetition priorities of columns, corresponding to information bits, in the mother matrix of the check matrix of the LDPC in rate matching may be sorted in descending order as the following sorting 6:
Sorting 6: 16, 9, 12, 7, 10, 8, 11, 14, 13, 15, 6, 4, 5, 1, 2, and 3.

Each element a in the sorting 6 indicates an a^{th} column of the mother matrix of the check matrix. In addition, indexes of columns in the mother matrix start from 1.

### (7) A code rate R = 3/4, and a code length L = 1944.

A mother matrix (denoted as a matrix 7) of a check matrix of the LDPC code whose code rate is 3/4 and code length is 1944 is provided as follows: $\left[\begin{matrix}48 & 29 & 28 & 39 & 9 & 61 & - & - & - & 63 & 45 & 80 & - & - & - & 37 & 32 & 22 & 1 & 0 & - & - & - & - \\ 4 & 49 & 42 & 48 & 11 & 30 & - & - & - & 49 & 17 & 41 & 37 & 15 & - & 54 & - & - & - & 0 & 0 & - & - & - \\ 35 & 76 & 78 & 51 & 37 & 35 & 21 & - & 17 & 64 & - & - & - & 59 & 7 & - & - & 32 & - & - & 0 & 0 & - & - \\ 9 & 65 & 44 & 9 & 54 & 56 & 73 & 34 & 42 & - & - & - & 35 & - & - & - & 46 & 39 & 0 & - & - & 0 & 0 & - \\ 3 & 62 & 7 & 80 & 68 & 26 & - & 80 & 55 & - & 36 & - & 26 & - & 9 & - & 72 & - & - & - & - & - & 0 & 0 \\ 26 & 75 & 33 & 21 & 69 & 59 & 3 & 38 & - & - & - & 35 & - & 62 & 36 & 26 & - & 1 & - & - & - & - & - & 0\end{matrix}\right]$

As shown above, a size of the matrix 7 is 12 × 24, and each element in the matrix 7 indicates a square matrix of z = 1944/24 = 81-order. "-" indicates an all-zero matrix of 81 × 81. Each element i in the matrix 7 indicates a circulant permutation matrix of 81 × 81, and i indicates a cyclic shift value. For example, i = 0 indicates an identity matrix whose size is 81 × 81.

Table 9 shows sorting of repetition priorities of information bits of an LDPC whose code rate is 3/4 and code length is 1944 in this application.

**Table 9**

| | | | | | | | | | |
|---|---|---|---|---|---|---|---|---|---|
| Reliability sorting | 12 (3) | 16 (3) | 11 (3) | 10 (3) | 14 (3) | 17 (3) | 15 (3) | 8 (3) | 13 (3) |
| \|*LLR*\| | 42.1947 | 42.1947 | 42.2473 | 42.3949 | 42.4339 | 42.4605 | 42.4782 | 42.4996 | 42.5079 |
| Reliability sorting | 18 (3) | 7 (3) | 9 (3) | 1 (6) | 2 (6) | 3 (6) | 4 (6) | 5 (6) | 6 (6) |
| \|*LLR*\| | 42.6081 | 42.6472 | 42.6998 | 81.8940 | 81.8940 | 81.8940 | 81.8940 | 81.8940 | 81.8940 |

In Table 9, a (b) indicates an a^{th} column of the mother matrix, and a column weight of the a^{th} column is b.

In addition, Table 9 provides sorting of the first column to the eighteenth column of the matrix 7, because the first column to the eighteenth column correspond to an information (or in other words, a system) part of the matrix. Codeword bits corresponding to these columns are all original information bits.

Each column in the mother matrix corresponds to z information bits of the original check matrix, and repetition priorities of the z codeword bits are the same. Because the matrix 7 gives a mother matrix, each column corresponds to 81 codeword bits of the original check matrix. The eighteenth column with the highest repetition priority in Table 9 is used as an example. 81 information bits, in the original check matrix, corresponding to the eighteenth column of the mother matrix have a same repetition priority.

As shown in Table 9, for the check matrix of the LDPC whose code rate is 3/4 and code length is 1944, repetition priorities of columns, corresponding to information bits, in the mother matrix of the check matrix of the LDPC in rate matching may be sorted in descending order as the following sorting 7:
Sorting 7: 12, 16, 11, 10, 14, 17, 15, 8, 13, 18, 7, 9, 6, 1, 2, 3, 4, 5, and 6.

Each element a in the sorting 7 indicates an a^{th} column of the mother matrix of the check matrix. In addition, indexes of columns in the mother matrix start from 1.

### (8) A code rate R = 3/4, and a code length L = 1296.

A mother matrix (denoted as a matrix 8) of a check matrix of the LDPC code whose code rate is 3/4 and code length is 1296 is provided as follows: $\left[\begin{matrix}39 & 40 & 51 & 41 & 3 & 29 & 8 & 36 & - & 14 & - & 6 & - & 33 & - & 11 & - & 4 & 1 & 0 & - & - & - & - \\ 48 & 21 & 47 & 9 & 48 & 35 & 51 & - & 38 & - & 28 & - & 34 & - & 50 & - & 50 & - & - & 0 & 0 & - & - & - \\ 30 & 39 & 28 & 42 & 50 & 39 & 5 & 17 & - & 6 & - & 18 & - & 20 & - & 15 & - & 40 & - & - & 0 & 0 & - & - \\ 29 & 0 & 1 & 43 & 36 & 30 & 47 & - & 49 & - & 47 & - & 3 & - & 35 & - & 34 & - & 0 & - & - & 0 & 0 & - \\ 1 & 32 & 11 & 23 & 10 & 44 & 12 & 7 & - & 48 & - & 4 & - & 9 & - & 17 & - & 16 & - & - & - & - & 0 & 0 \\ 13 & 7 & 15 & 47 & 23 & 16 & 47 & - & 43 & - & 29 & - & 52 & - & 53 & - & 53 & - & 1 & - & - & - & - & 0\end{matrix}\right]$

As shown above, a size of the matrix 8 is 12 × 24, and each element in the matrix 8 indicates a square matrix of z = 1296/24 = 54-order. "-" indicates an all-zero matrix of 54 × 54. Each element i in the matrix 8 indicates a circulant permutation matrix of 54 × 54, and i indicates a cyclic shift value. For example, i = 0 indicates an identity matrix whose size is 54 × 54.

Table 10 shows sorting of repetition priorities of information bits of an LDPC whose code rate is 3/4 and code length is 1296.

**Table 10**

| | | | | | | | | | |
|---|---|---|---|---|---|---|---|---|---|
| Reliability sorting | 9 (3) | 11 (3) | 13 (3) | 15 (3) | 17 (3) | 8 (3) | 10 (3) | 12 (3) | 14 (3) |
| \|*LLR*\| | 42.4009 | 42.4009 | 42.4009 | 42.4009 | 42.4009 | 42.5957 | 42.5957 | 42.5957 | 42.5957 |
| Reliability sorting | 16 (3) | 18 (3) | 1 (6) | 2 (6) | 3 (6) | 4 (6) | 5 (6) | 6 (6) | 7 (6) |
| \|*LLR*\| | 42.5957 | 42.5957 | 81.9962 | 81.9962 | 81.9962 | 81.9962 | 81.9962 | 81.9962 | 81.9962 |

In Table 10, a (b) indicates an a^{th} column of the mother matrix, and a column weight of the a^{th} column is b.

In addition, Table 10 provides sorting of the first column to the eighteenth column of the matrix 8, because the first column to the eighteenth column correspond to an information (or in other words, a system) part of the matrix. Codeword bits corresponding to these columns are all original information bits.

Each column in the mother matrix corresponds to z information bits of the original check matrix, and repetition priorities of the z codeword bits are the same. Because the matrix 7 gives a mother matrix, each column corresponds to 54 codeword bits of the original check matrix. The ninth column with the highest repetition priority in Table 10 is used as an example. 54 information bits, in the original check matrix, corresponding to the ninth column of the mother matrix have a same repetition priority.

As shown in Table 10, for the check matrix of the LDPC whose code rate is 3/4 and code length is 1296, repetition priorities of columns, corresponding to information bits, in the mother matrix of the check matrix of the LDPC in rate matching may be sorted in descending order as the following sorting 8:
Sorting 8: 9, 11, 13, 15, 17, 8, 10, 12, 14,16, 18, 1, 2, 3, 4, 5, 6, 7.

Each element a in the sorting 8 indicates an a^{th} column of the mother matrix of the check matrix. In addition, indexes of columns in the mother matrix start from 1.

### (9) A code rate R = 3/4, and a code length L = 648.

A mother matrix (denoted as a matrix 9) of a check matrix of the LDPC code whose code rate is 3/4 and code length is 648 is provided as follows: $\left[\begin{matrix}16 & 17 & 22 & 24 & 9 & 3 & 14 & - & 4 & 2 & 7 & - & 26 & - & 2 & - & 21 & - & 1 & 0 & - & - & - & - \\ 25 & 12 & 12 & 3 & 3 & 26 & 6 & 21 & - & 15 & 22 & - & 15 & - & 4 & - & - & 16 & - & 0 & 0 & - & - & - \\ 25 & 18 & 26 & 16 & 22 & 23 & 9 & - & 0 & - & 4 & - & 4 & - & 8 & 23 & 11 & - & - & - & 0 & 0 & - & - \\ 9 & 7 & 0 & 1 & 17 & - & - & 7 & 3 & - & 3 & 23 & - & 16 & - & - & 21 & - & 0 & - & - & 0 & 0 & - \\ 24 & 5 & 26 & 7 & 1 & - & - & 15 & 24 & 15 & - & 8 & - & 13 & - & 13 & - & 11 & - & - & - & - & 0 & 0 \\ 2 & 2 & 19 & 14 & 24 & 1 & 15 & 19 & - & 21 & - & 2 & - & 24 & - & 3 & - & 2 & 1 & - & - & - & - & 0\end{matrix}\right]$

As shown above, a size of the matrix 9 is 12 × 24, and each element in the matrix 9 indicates a square matrix of z = 648/24 = 27-order. "-" indicates an all-zero matrix of 27 × 27. Each element i in the matrix 9 indicates a circulant permutation matrix of 27 × 27, and i indicates a cyclic shift value. For example, i = 0 indicates an identity matrix whose size is 27 × 27.

Table 11 shows sorting of repetition priorities of information bits of an LDPC whose code rate is 3/4 and code length is 648 in this application.

**Table 11**

| | | | | | | | | | |
|---|---|---|---|---|---|---|---|---|---|
| Reliability sorting | 18 (3) | 13 (3) | 15 (3) | 16 (3) | 12 (3) | 14 (3) | 17 (3) | 10 (4) | 6 (4) |
| \|*LLR*\| | 55.6613 | 57.4149 | 57.4149 | 57.8154 | 57.9725 | 57.9725 | 59.7288 | 72.4135 | 74.3434 |
| Reliability sorting | 7 (4) | 8 (4) | 11 (4) | 9 (4) | 1 (6) | 2 (6) | 3 (6) | 4 (6) | 5 (6) |
| \|*LLR*\| | 74.3434 | 76.0379 | 77.7915 | 78.0157 | 113.0070 | 113.0070 | 113.0070 | 113.0070 | 113.0070 |

In Table 11, a (b) indicates an a^{th} column of the mother matrix, and a column weight of the a^{th} column is b.

In addition, Table 11 provides sorting of the first column to the eighteenth column of the matrix 9, because the first column to the eighteenth column correspond to an information (or in other words, a system) part of the matrix. Codeword bits corresponding to these columns are all original information bits.

Each column in the mother matrix corresponds to z information bits of the original check matrix, and repetition priorities of the z codeword bits are the same. Because the matrix 9 gives a mother matrix, each column corresponds to 27 codeword bits of the original check matrix. The eighteenth column with the highest repetition priority in Table 10 is used as an example. 27 information bits corresponding to the eighteenth column of the mother matrix have a same repetition priority.

As shown in Table 11, for the check matrix of the LDPC whose code rate is 3/4 and code length is 648, repetition priorities of columns, corresponding to information bits, in the mother matrix of the check matrix of the LDPC in rate matching may be sorted in descending order as the following sorting 9:
Sorting 9: 18, 13, 15, 16, 12, 14, 17, 10, 6, 7, 8, 11, 9, 1, 2, 3, 4, and 5.

Each element a in the sorting 9 indicates an a^{th} column of the mother matrix of the check matrix. In addition, indexes of columns in the mother matrix start from 1.

### (10) A code rate R = 5/6, and a code length L = 1944.

A mother matrix (denoted as a matrix 10) of a check matrix of the LDPC code whose code rate is 5/6 and code length is 1944 is provided as follows: $\left[\begin{matrix}13 & 48 & 80 & 66 & 4 & 74 & 7 & 30 & 76 & 52 & 37 & 60 & - & 49 & 73 & 31 & 74 & 73 & 23 & - & 1 & 0 & - & - \\ 69 & 63 & 74 & 56 & 64 & 77 & 57 & 65 & 6 & 16 & 51 & - & 64 & - & 68 & 9 & 48 & 62 & 54 & 27 & - & 0 & 0 & - \\ 51 & 15 & 0 & 80 & 24 & 25 & 42 & 54 & 44 & 71 & 71 & 9 & 67 & 35 & - & - & - & 29 & - & 53 & 0 & - & 0 & 0 \\ 16 & 29 & 36 & 41 & 44 & 56 & 59 & 37 & 50 & 24 & - & 65 & 4 & 65 & 52 & 58 & 4 & - & 73 & 52 & 1 & - & - & 0\end{matrix}\right]$

As shown above, a size of the matrix 10 is 8 × 24, and each element in the matrix 10 indicates a square matrix of z = 1944/24 = 81-order. "-" indicates an all-zero matrix of 81 × 81. Each element i in the matrix 10 indicates a circulant permutation matrix of 81 × 81, and i indicates a cyclic shift value. For example, i = 0 indicates an identity matrix whose size is 81 × 81.

Table 12 shows sorting of repetition priorities of information bits of an LDPC whose code rate is 5/6 and code length is 1944 in this application.

**Table 12**

| | | | | | | | | | | |
|---|---|---|---|---|---|---|---|---|---|---|
| Reliability sorting | 12 (3) | 14 (3) | 15 (3) | 17 (3) | 19 (3) | 13 (3) | 20 (3) | 11 (3) | 16 (3) | 18 (3) |
| \|*LLR*\| | 81.7266 | 81.7266 | 81.8447 | 81.8447 | 81.8447 | 85.7235 | 85.7235 | 85.8668 | 85.8668 | 85.8668 |
| Reliability sorting | 12 (3) | 14 (3) | 15 (3) | 17 (3) | 19 (3) | 13 (3) | 20 (3) | 11 (3) | 16 (3) | 18 (3) |
| Reliability sorting | 1 (4) | 2 (4) | 3 (4) | 4 (4) | 5 (4) | 6 (4) | 7 (4) | 8 (4) | 9 (4) | 10 (4) |
| \|*LLR*\| | 111.6094 | 111.6094 | 111.6094 | 111.6094 | 111.6094 | 111.6094 | 111.6094 | 111.6094 | 111.6094 | 111.6094 |

In Table 12, a (b) indicates an a^{th} column of the mother matrix, and a column weight of the a^{th} column is b.

In addition, Table 12 provides sorting of the first column to the twentieth column of the matrix 10, because the first column to the twentieth column correspond to an information (or in other words, a system) part of the matrix. Codeword bits corresponding to these columns are all original information bits.

Each column in the mother matrix corresponds to z information bits of the original check matrix, and repetition priorities of the z codeword bits are the same. Because the matrix 10 gives a mother matrix, each column corresponds to 81 codeword bits of the original check matrix. The twelfth column with the highest repetition priority in Table 12 is used as an example. 81 information bits, in the original check matrix, corresponding to the twelfth column of the mother matrix have a same repetition priority.

As shown in Table 12, for the check matrix of the LDPC whose code rate is 5/6 and code length is 1944, repetition priorities of columns, corresponding to information bits, in the mother matrix of the check matrix of the LDPC in rate matching may be sorted in descending order as the following sorting 10:
Sorting 10: 12, 14, 15, 17, 19, 13, 20, 11, 16, 18, 1, 2, 3, 4, 5, 6, 7, 8, 9, and 10.

Each element a in the sorting 10 indicates an a^{th} column of the mother matrix of the check matrix. In addition, indexes of columns in the mother matrix start from 1.

### (11) A code rate R = 5/6, and a code length L = 1296.

A mother matrix (denoted as a matrix 11) of a check matrix of the LDPC code whose code rate is 5/6 and code length is 1296 is provided as follows: $\left[\begin{matrix}48 & 29 & 37 & 52 & 2 & 16 & 6 & 14 & 53 & 31 & 34 & 5 & 18 & 42 & 53 & 31 & 45 & - & 46 & 52 & 1 & 0 & - & - \\ 17 & 4 & 30 & 7 & 43 & 11 & 24 & 6 & 14 & 21 & 6 & 39 & 17 & 40 & 47 & 7 & 15 & 41 & 19 & - & - & 0 & 0 & - \\ 7 & 2 & 51 & 31 & 46 & 23 & 16 & 11 & 53 & 40 & 10 & 7 & 46 & 53 & 33 & 35 & - & 25 & 35 & 38 & 0 & - & 0 & 0 \\ 19 & 48 & 41 & 1 & 10 & 7 & 36 & 47 & 5 & 29 & 52 & 52 & 31 & 10 & 26 & 6 & 3 & 2 & - & 51 & 1 & - & - & 0\end{matrix}\right]$

As shown above, a size of the matrix 11 is 8 × 24, and each element in the matrix 11 indicates a square matrix of z = 1296/24 = 54-order. "-" indicates an all-zero matrix of 54 × 54. Each element i in the matrix 11 indicates a circulant permutation matrix of 54 × 54, and i indicates a cyclic shift value. For example, i = 0 indicates an identity matrix whose size is 54 × 54.

Table 13 shows sorting of repetition priorities of information bits of an LDPC whose code rate is 5/6 and code length is 1296 in this application.

**Table 13**

| | | | | | | | | | | |
|---|---|---|---|---|---|---|---|---|---|---|
| Reliability sorting | 17 (3) | 20 (3) | 19 (3) | 18 (3) | 1 (3) | 2 (3) | 3 (3) | 4 (3) | 5 (3) | 6 (3) |
| *LLR* | 40.1126 | 40.1137 | 41.5050 | 41.5277 | 53.5355 | 53.5355 | 53.5355 | 53.5355 | 53.5355 | 53.5355 |
| Reliability sorting | 7 (4) | 8 (4) | 9 (4) | 10 (4) | 11 (4) | 12 (4) | 13 (4) | 14 (4) | 15 (4) | 16 (4) |
| \|*LLR*\| | 53.5355 | 53.5355 | 53.5355 | 53.5355 | 53.5355 | 53.5355 | 53.5355 | 53.5355 | 53.5355 | 53.5355 |

In Table 13, a (b) indicates an a^{th} column of the mother matrix, and a column weight of the a^{th} column is b.

In addition, Table 13 provides sorting of the first column to the twentieth column of the matrix 11, because the first column to the twentieth column correspond to an information (or in other words, a system) part of the matrix. Codeword bits corresponding to these columns are all original information bits.

Each column in the mother matrix corresponds to z information bits of the original check matrix, and repetition priorities of the z codeword bits are the same. Because the matrix **11** gives a mother matrix, each column corresponds to 54 codeword bits of the original check matrix. The seventeenth column with the highest repetition priority in Table 13 is used as an example. 54 information bits, in the original check matrix, corresponding to the seventeenth column of the mother matrix have a same repetition priority.

As shown in Table 13, for the check matrix of the LDPC whose code rate is 5/6 and code length is 1296, repetition priorities of columns, corresponding to information bits, in the mother matrix of the check matrix of the LDPC in rate matching may be sorted in descending order as the following sorting **11:**
Sorting 11: 17, 20, 19, 17, 19, 13, 20, 11, 16, 18, 1, 2, 3, 4, 5, 6, 7, 8, 9, and 10.

Each element a in the sorting 11 indicates an a^{th} column of the mother matrix of the check matrix. In addition, indexes of columns in the mother matrix start from 1.

### (12) A code rate R = 5/6, and a code length L = 648.

A mother matrix (denoted as a matrix 12) of a check matrix of the LDPC code whose code rate is 5/6 and code length is 648 is provided as follows: $\left[\begin{matrix}17 & 13 & 8 & 21 & 9 & 3 & 18 & 12 & 10 & 0 & 4 & 15 & 19 & 2 & 5 & 10 & 16 & 19 & 13 & 13 & 1 & 0 & - & - \\ 3 & 12 & 11 & 14 & 11 & 25 & 5 & 18 & 0 & 9 & 2 & 26 & 26 & 10 & 24 & 7 & 14 & 20 & 4 & 2 & - & 0 & 0 & - \\ 22 & 16 & 4 & 3 & 10 & 21 & 12 & 5 & 21 & 14 & 19 & 5 & - & 8 & 5 & 18 & 11 & 5 & 5 & 15 & 0 & - & 0 & 0 \\ 17 & 7 & 14 & 14 & 4 & 16 & 16 & 24 & 24 & 10 & 1 & 7 & 15 & 6 & 10 & 26 & 8 & 18 & 21 & 14 & 1 & - & - & 0\end{matrix}\right]$

As shown above, a size of the matrix 12 is 8 × 24, and each element in the matrix 12 indicates a square matrix of z = 648/24 = 27-order. "-" indicates an all-zero matrix of 27 × 27. Each element i in the matrix 12 indicates a circulant permutation matrix of 27 × 27, and i indicates a cyclic shift value. For example, i = 0 indicates an identity matrix whose size is 27 × 27.

Table 14 shows sorting of repetition priorities of information bits of an LDPC whose code rate is 5/6 and code length is 648 in this application.

**Table 14**

| | | | | | | | | | | |
|---|---|---|---|---|---|---|---|---|---|---|
| Reliability sorting | 13 (3) | 1 (3) | 2 (3) | 3 (3) | 4 (3) | 5 (3) | 6 (4) | 7 (4) | 8 (4) | 9 (4) |
| \|*LLR*\| | 53.3878 | 73.4420 | 73.4420 | 73.4420 | 73.4420 | 73.4420 | 73.4420 | 73.4420 | 73.4420 | 73.4420 |
| Reliability sorting | 10 (4) | 11 (4) | 12 (4) | 14 (4) | 15 (4) | 16 (4) | 17 (4) | 18 (4) | 19 (4) | 20 (4) |
| \|*LLR*\| | 73.4420 | 73.4420 | 73.4420 | 73.4420 | 73.4420 | 73.4420 | 73.4420 | 73.4420 | 73.4420 | 73.4420 |

In Table 14, a (b) indicates an a^{th} column of the mother matrix, and a column weight of the a^{th} column is b.

In addition, Table 14 provides sorting of the first column to the twentieth column of the matrix 12, because the first column to the twentieth column correspond to an information (or in other words, a system) part of the matrix. Codeword bits corresponding to these columns are all original information bits.

Each column in the mother matrix corresponds to z information bits of the original check matrix, and repetition priorities of the z codeword bits are the same. Because the matrix 12 gives a mother matrix, each column corresponds to 27 codeword bits of the original check matrix. The thirteenth column with the highest repetition priority in Table 14 is used as an example. 27 information bits, in the original check matrix, corresponding to the thirteenth column of the mother matrix have a same repetition priority.

As shown in Table 14, for the check matrix of the LDPC whose code rate is 5/6 and code length is 648, repetition priorities of columns, corresponding to information bits, in the mother matrix of the check matrix of the LDPC in rate matching may be sorted in descending order as the following sorting 12:
Sorting 12: 13, 1, 2, 3, 4, 5, 6, 7, 8, 9, 10, 11, 12, 14, 15, 16, 17, 18, 19, and 20.

Each element a in the sorting 12 indicates an a^{th} column of the mother matrix of the check matrix. In addition, indexes of columns in the mother matrix start from 1.

The foregoing provides sorting of repetition priorities of information bits in three code lengths and four code rates provided in this application. The following uses an example to describe the application of the repetition priority in the IR-HARQ.

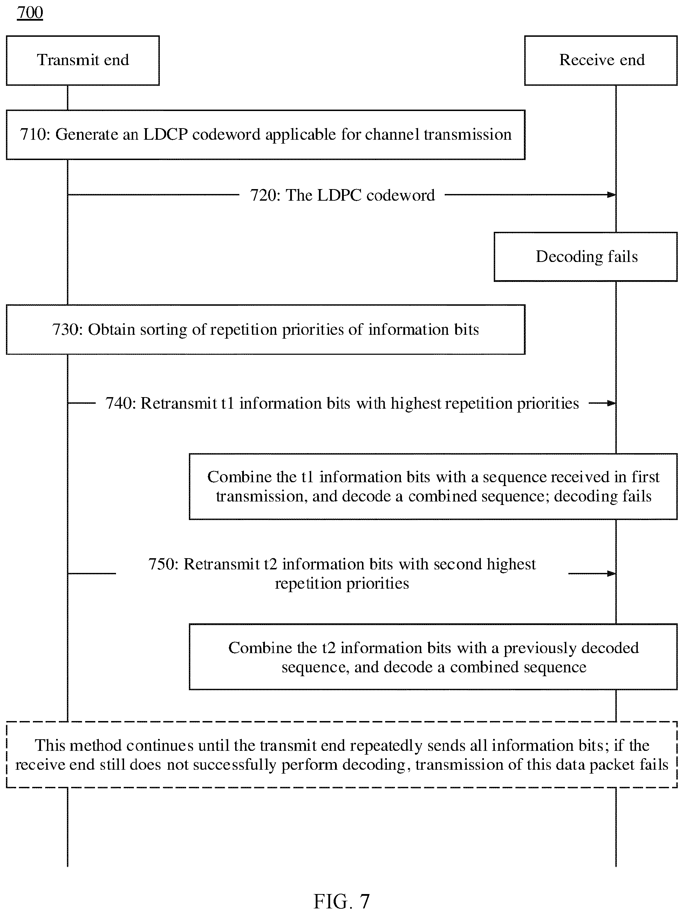

FIG. 7 is an application example of a repetition scheme in the IR-HARQ according to this application.

510: A transmit end generates an LDPC codeword applicable to channel transmission. For example, a bit rate of the LDPC codeword is 1/2.

520: The transmit end sends the LDPC codeword.

The following defines this transmission as the first transmission.

If a receive end can correctly decode all information bits (that is, system bits), transmission of this data packet ends. If a receive end cannot perform decoding correctly, the receive end requests the transmit end to perform retransmission. A retransmission process may be step 530 and subsequent steps.

530: The transmit end obtains an order of repetition priorities of information bits.

540: The transmit end retransmits, based on the order of the repetition priorities, t1 information bits with highest repetition priorities.

The receive end receives the t1 information bits retransmitted by the transmit end, combines the t1 information bits with corresponding information bits of a previously received sequence, and then performs decoding. If the receive end still cannot correctly perform decoding, when a preset maximum quantity of retransmission times is not reached, the receive end continues to request the transmit end to perform retransmission.

550: The transmit end retransmits, based on the order of the repetition priorities, t2 information bits with the second highest repetition priorities.

The receive end receives the t2 information bits retransmitted by the transmit end, combines the t2 information bits with the previously received t1 information bits and corresponding information bits of the sequence received in the first transmission, and then performs decoding.

The rest may be deduced by analogy until the transmit end repeatedly sends all information bits. If the receive end still cannot correctly recover the information bits, it indicates that transmission of the data packet fails. Transmission of the data packet is ended, and transmission of a next data packet is performed.

In the foregoing transmission process, a bit rate of an *l*^{th} transmission may meet the following formula (3): $\frac{k}{n + k} \leq {R}_{e} = \frac{k}{n + {\sum }_{i = 0}^{l} {t}_{i}} \leq {R}_{c}$

In formula (3), *R_{c}* is a code rate of the LDPC codeword sent by the transmit end for the first time (for example, 1/2 in step 510), k indicates a quantity of system bits, and n indicates a length of a mother code codeword of the LDPC. A redundancy amount added in the first transmission is t0 = 0.

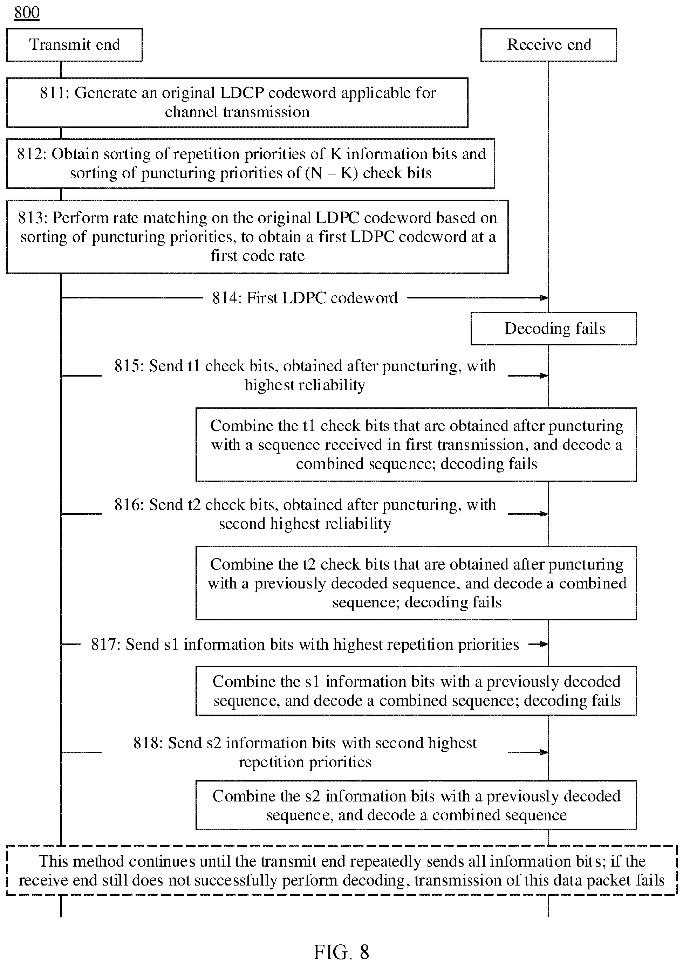

In addition, an information bit repetition scheme provided in this application may be used in combination with a check bit puncturing scheme. The following uses an example with reference to FIG. 8.

FIG. 8 is an application example of a combination of an information bit repetition scheme and a check bit puncturing scheme in the IR-HARQ according to this application.

611: A transmit end generates an original LDPC codeword applicable to channel transmission. For example, a bit rate of the original LDPC codeword is 1/2.

It is assumed that a code length of a mother code of the LDPC is N, a quantity of information bits is K, and a quantity of check bits is (N - K), where both N and K are positive integers.

612: The transmit end obtains an order of repetition priorities of the K information bits and an order of puncturing priorities of the (N - K) check bits.

It should be understood that a higher repetition priority of an information bit indicates higher reliability of the information bit, and therefore a higher retransmission priority. On the other hand, a higher puncturing priority of a check bit indicates lower reliability of the check bit and a higher puncturing priority of the check bit in a rate matching process, but a lower retransmission priority.

613: The transmit end punctures the original LDPC codeword (it is assumed that only check bits are punctured) based on the order of puncturing priorities of the (N - K) check bits, to obtain an LDPC codeword (denoted as a first LDPC codeword below) at a target code rate expected during first transmission. For example, a code rate of the obtained first LDPC codeword is 5/6 by puncturing an original LDPC codeword.

614: Send the first LDPC codeword.

If a receive end can correctly decode all information bits, transmission of this data packet ends. If a receive end cannot perform decoding correctly, the receive end requests the transmit end to perform retransmission. A retransmission process may be step 615 and subsequent steps.

615: The transmit end first sends t1 check bits that are with highest reliability and that are obtained after puncturing.

The t1 check bits that are with the highest reliability and that are obtained after puncturing are first t1 check bits sorted in ascending order of puncturing priorities.

In this embodiment, the check bits obtained after puncturing are check bits obtained after puncturing in a rate matching process in first transmission.

The receive end receives the t1 check bits obtained after puncturing, combines the t1 check bits obtained after puncturing and a sequence received during first transmission into one sequence, and then performs decoding.

If the receive end still cannot correctly perform decoding, when a preset maximum quantity of retransmission times is not reached, the receive end continues to request the transmit end to perform retransmission.

616: The transmit end then sends t2 check bits that are with second highest reliability and that are obtained after puncturing.

The t2 check bits that are with the second highest reliability and that are obtained after puncturing are first t2 check bits obtained after puncturing sorted in ascending order of puncturing priorities in remaining to-be-punctured check bits other than the t1 check bits in all check bits obtained after puncturing.

The receive end receives the t2 check bits obtained after puncturing, combines, into one sequence, the t2 check bits obtained after puncturing, the sequence received during first transmission, and the t1 check bits obtained after puncturing, and then performs decoding.

By analogy, until the transmit end sends all the check bits obtained after puncturing, if the receive end still cannot correctly perform decoding, the transmit end considers sending the information bits.

617: The transmit end sends s1 information bits with highest repetition priority.

The receive end receives the s1 information bits, combines the s1 information bits with a previously decoded sequence, and decodes a combined sequence. If the receive end still cannot correctly perform decoding, when a preset maximum quantity of retransmission times is not reached, the receive end continues to request the transmit end to perform retransmission.

618: The transmit end sends s2 information bits with second highest repetition priority.

The receive end receives the s2 information bits, combines the s2 information bits with a previous decoded sequence, and decodes a combined sequence. The rest may be deduced by analogy until the transmit end repeatedly sends all the information bits. In this case, if the receive end still cannot correctly decode the information bits, it indicates that transmission of this data packet fails. Transmission of the data packet ends, and transmission of a next data packet is performed.

In the example in FIG. 8, the transmit end sends the first LDPC codeword. If the receive end does not successfully perform decoding, the transmit end first sends the check bits obtained after puncturing based on the puncturing priorities of the check bits until all the check bits are sent. If the receive end still does not successfully perform decoding, the transmit end repeatedly sends the information bits in the first LDPC codeword based on the repetition priorities of the information bits.

In another example, for the first LDPC codeword of the transmit end, if the receive end does not successfully perform decoding, the transmit end may first repeatedly send the information bits in the first LDPC codeword based on the repetition priorities of the information bits until all the information bits are repeatedly sent. If the receive end still does not successfully perform decoding, the transmit end sends the check bits obtained after puncturing based on the puncturing priorities of the check bits.

In other words, a sequence of the puncturing scheme and the repetition scheme in combination is not limited in embodiments of this application. To be specific, if the LDPC codeword sent by the transmit end is not successfully decoded by the receive end, the transmit end may first perform the repetition scheme and then perform the puncturing scheme, or may first perform the repetition scheme and then perform the puncturing scheme.

In the foregoing transmission process, a bit rate of an *l*^{th} transmission may meet the following formula (4): $\frac{k}{n + k} \leq {R}_{e} = \frac{k}{n - {n}_{cp} + {\sum }_{i = 0}^{min \left(l, {t}_{p}\right)} {t}_{i} + {\sum }_{i = 0}^{max \left(l-{t}_{p},0\right)} {s}_{i}} \leq {R}_{c}^{′} = \frac{k}{n - {n}_{cp}}$

In formula (4), *R_{c} = k* / *n,* ${n}_{cp} = {\sum }_{i = 0}^{{t}_{p}} {t}_{i}$, and n indicates a length of a mother code codeword of the LDPC.

Compared with a rate compatible puncture latitude HARQ (rate compatible puncture latitude HARQ, RCPL-HARQ) technology and a rate compatible repeat latitude HARQ (rate compatible repeat latitude HARQ, RCRL-HARQ) technology, a rate compatible latitude HARQ (rate compatible latitude HARQ, RCL-HARQ) technology can implement a more flexible bit rate.

The foregoing describes in detail the LDPC repetition scheme and a combination scheme of the repetition scheme and the puncturing scheme provided in this application with reference to FIG. 1 to FIG. 8. The following provides a comparison between simulation results of a BER and an FER in the LDPC repetition scheme provided in this application and those of a conventional repetition scheme.

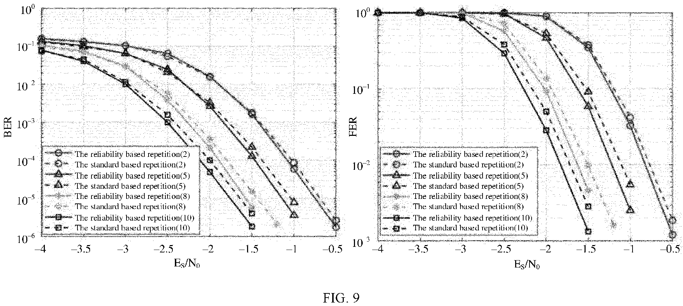

FIG. 9 to FIG. 19 are FER curves and throughput curves of a system under various IR-HARQ transmission policies.

Simulation parameters in FIG. 9 to FIG. 19 are set as follows: AWGAN channel; BPSK modulation; log-SPA decoding; a maximum quantity of iterative decoding times is 10; a stop-wait retransmission request policy is used; and a maximum quantity of transmissions for restoring data of each frame is 4.

In addition, performance evaluation parameters considered in FIG. 9 to FIG. 19 are mainly a frame error rate (frame error rate, FER) and throughput (throughput). Throughput = (Quantity of correctly received frames × k)/Total quantity of sent bits. k is a quantity of information bits of each frame. In addition, Eₛ/N₀ in each figure indicates a symbol signal-to-noise ratio.

An LDPC code in a conventional method is a QC-LDPC code whose code length is 1944 or 972 in an 802.11ac standard.

Specifically, FIG. 9 shows BER performance comparison between the repetition scheme in this application and the conventional repetition scheme under different repetition quantities of information bits when a code length N = 1944 and a code rate R = 1/2.

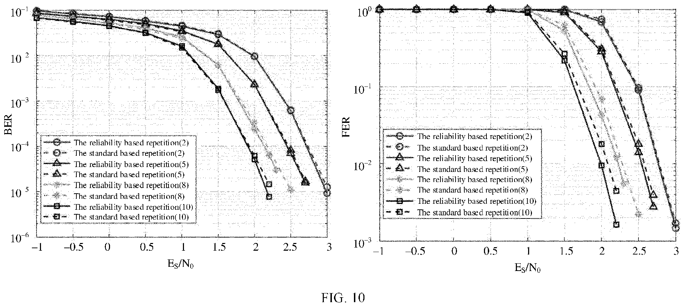

FIG. 10 shows BER performance comparison between the repetition scheme in this application and the conventional repetition scheme under different repetition quantities of information bits when a mother code length N = 1944 and a code rate R = 5/6.

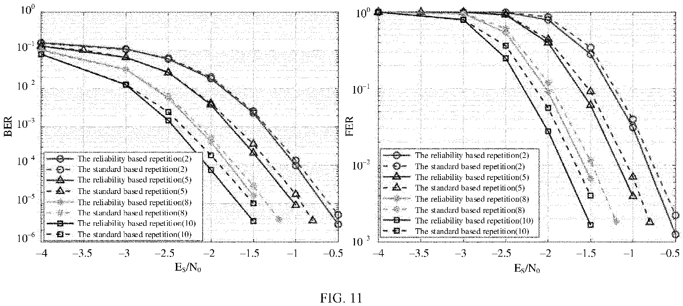

FIG. 11 shows BER performance comparison between the repetition scheme in this application and the conventional repetition scheme under different repetition quantities of information bits when a mother code length N = 1920 and a code rate R = 1/2.

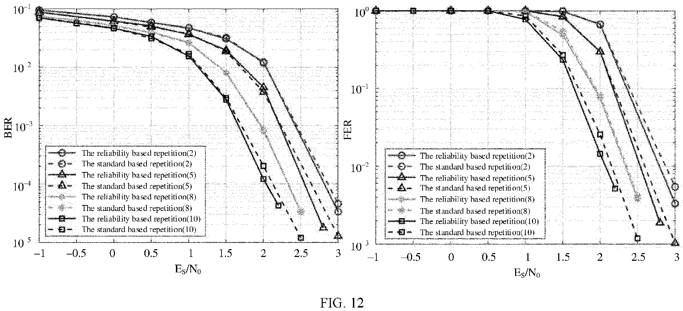

FIG. 12 shows BER performance comparison between the repetition scheme in this application and the conventional repetition scheme under different repetition quantities of information bits when a mother code length N = 1920 and a code rate R = 5/6.

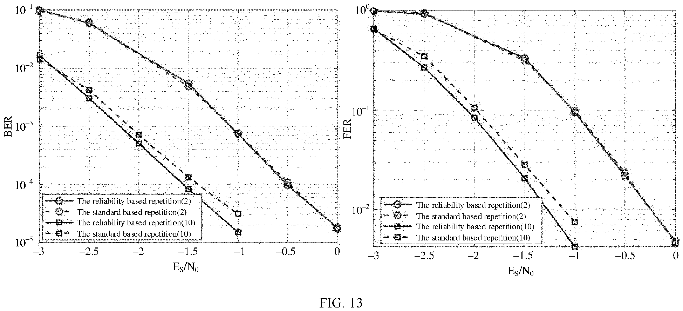

FIG. 13 shows BER performance comparison between the repetition scheme in this application and the conventional repetition scheme under different repetition quantities of information bits when a mother code length N = 648 and a code rate R = 1/2.

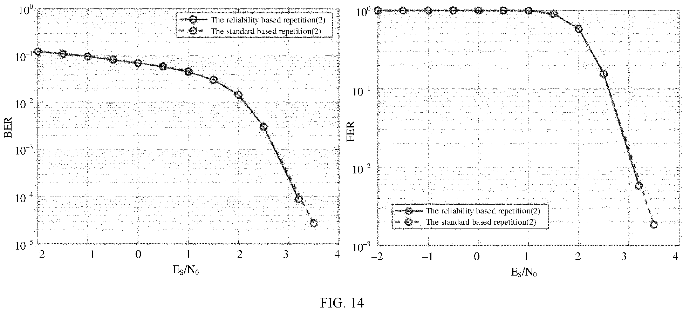

FIG. 14 shows BER performance comparison between the repetition scheme in this application and the conventional repetition scheme under different repetition quantities of information bits when a mother code length N = 648 and a code rate R = 5/6.

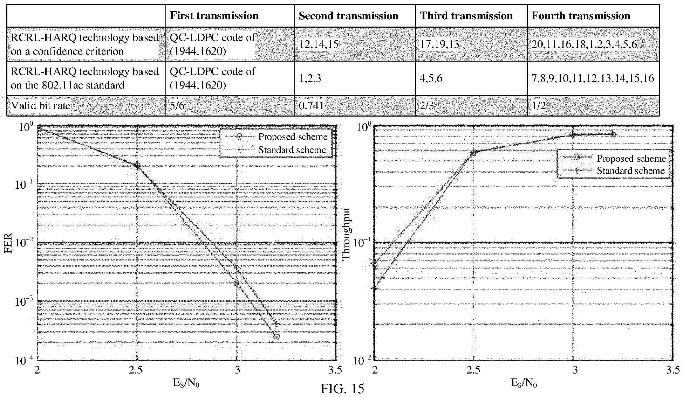

FIG. 15 is a simulation result 1 of a QC-LDPC, of (1944, 1620), whose code rate is 5/6 in the IR-HARQ technology.

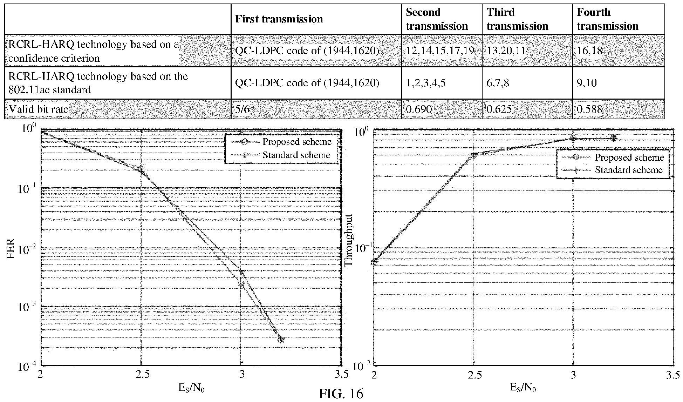

FIG. 16 is a simulation result 2 of a QC-LDPC, of (1944, 1620), whose code rate is 5/6 in the IR-HARQ technology.

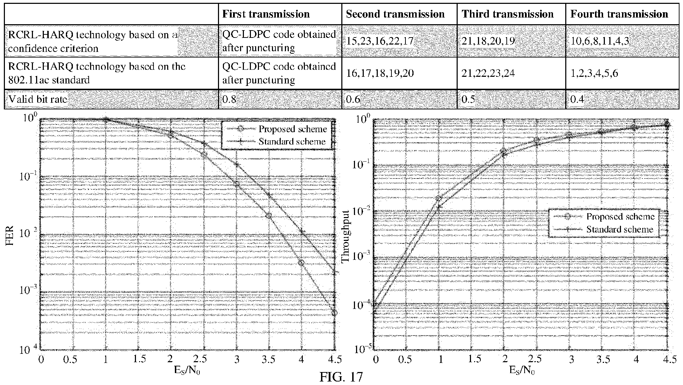

FIG. 17 is a simulation result 3 of a QC-LDPC, of (1944, 972), whose code rate is 1/2 in the IR-HARQ technology.

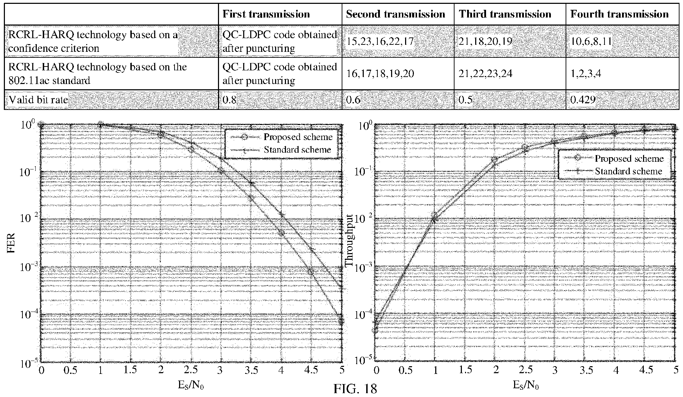

FIG. 18 is a simulation result 4 of a QC-LDPC, of (1944, 972), whose code rate is 1/2 in the IR-HARQ technology.

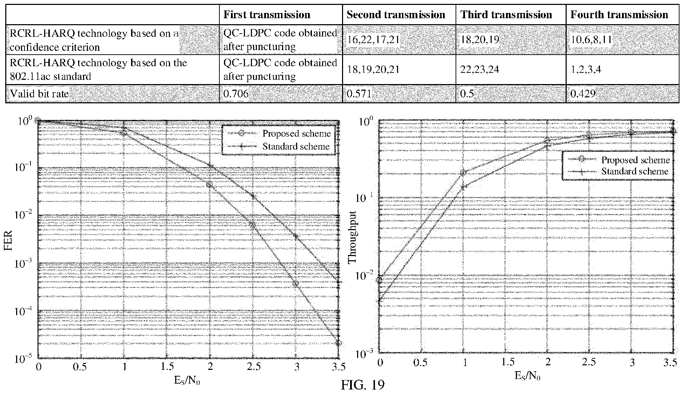

FIG. 19 is a simulation result 5 of a QC-LDPC, of (1944, 972), whose code rate is 1/2 in the IR-HARQ technology.

In FIG. 9 to FIG. 14, a curve corresponding to "the reliability based repetition" indicates a performance curve of the repetition scheme in this application, and a curve corresponding to "the standard based puncturing" indicates a performance curve of the conventional repetition scheme. A number in parentheses after repetition indicates a quantity of repetitions of information bits, and is in a unit of column. For example, repetition (2) indicates that the repetition quantity is two columns, and repetition (5) indicates that the repetition quantity is five columns.

In the legends in FIG. 9 to FIG. 19, each "proposed scheme" indicates a solution provided in this application, and each "standard scheme" indicates a standard (namely, the foregoing 802.11ac standard) scheme, namely, a conventional scheme.

It can be learned from FIG. 15 to FIG. 19 that, for a same Eₛ/N₀, the repetition scheme in this application has a lower FER and a higher throughput, indicating that the repetition scheme in this application is better than the conventional repetition scheme.

The following describes a communication apparatus provided in this application.

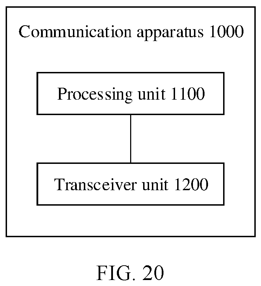

FIG. 20 is a schematic block diagram of a communication apparatus 1000 according to this application. As shown in FIG. 20, the communication apparatus 1000 includes a processing unit 1100 and a transceiver unit 1200.

Optionally, the transceiver unit 1200 may alternatively be replaced with a sending unit or a receiving unit. For example, when performing a sending action, the transceiver unit 1200 may be replaced with the sending unit. When performing a receiving action, the transceiver unit 1200 may be replaced with the receiving unit.

The processing unit 1100 is configured to perform rate matching on a first LDPC codeword at a first code rate based on an order of repetition priorities of K information bits of a mother code of an LDPC in a rate matching process, to obtain a second LDPC codeword at a second code rate, where K is a quantity of information bits included in the LDPC mother code, and K is a positive integer.

The transceiver unit 1200 is configured to send the second LDPC codeword.

Optionally, in an embodiment, the processing unit 1100 is further configured to:
repeat, in descending order of repetition priorities, information bits in a first information bit set in the first LDPC codeword based on a quantity L of bits that need to be repeated and the order of repetition priorities of the K information bits in a rate matching process, where a repetition priority of an information bit with a lowest repetition priority in the first information bit set is higher than or equal to a repetition priority of a remaining information bit in the first LDPC codeword other than the information bits in the first information bit set, L ≤ K, and L is an integer.

Optionally, in an embodiment, the order of the repetition priorities of the K information bits is specifically:
an order of repetition priorities of columns, corresponding to information bits, in a mother matrix of a check matrix of an LDPC whose quantity of information bits is K, mother code length is N, and code rate is R, where each column in the mother matrix corresponds to z codeword bits of the LDPC, z = N/n, n is a total quantity of columns included in the mother matrix, and the check matrix of the LDPC is obtained by extending the mother matrix; and each element i in the mother matrix indicates a cyclic shift matrix of z × z, i indicates a cyclic shift value, i ≥ 0, i is an integer, N ≥ K, N is an integer, and R = K/N.

Optionally, in an embodiment, the mother code length is 1944, the code rate is 1/2, and in descending order of repetition priorities, repetition priorities of columns, in the mother matrix, corresponding to information bits, are sorted as follows:
10, 6, 8, 11, 4, 3, 12, 7, 2, 5, 9, and 1.

Each element a in the sorting indicates an a^{th} column of the mother matrix.

Optionally, in an embodiment, the mother code length is 1296, the code rate is 1/2, and in descending order of repetition priorities, repetition priorities of columns, in the mother matrix, corresponding to information bits, are sorted as follows:
8, 12, 7, 3, 11, 10, 4, 6, 2, 5, 9, and 1.

Each element a in the sorting indicates an a^{th} column of the mother matrix.

Optionally, in an embodiment, the mother code length is 648, the code rate is 1/2, and in descending order of repetition priorities, repetition priorities of columns, in the mother matrix, corresponding to information bits, are sorted as follows:
8, 6, 12, 11, 2, 3, 10, 7, 4, 1, 5, and 9.

Each element a in the sorting indicates an a^{th} column of the mother matrix.

Optionally, in an embodiment, the mother code length is 1944, the code rate is 2/3, and in descending order of repetition priorities, repetition priorities of columns, in the mother matrix, corresponding to information bits, are sorted as follows:
16, 8, 15, 12, 9, 10, 14, 6, 13, 11, 7, 5, 1, 2, 3, and 4.

Each element a in the sorting indicates an a^{th} column of the mother matrix.

Optionally, in an embodiment, the mother code length is 1296, the code rate is 2/3, and in descending order of repetition priorities, repetition priorities of columns, in the mother matrix, corresponding to information bits, are sorted as follows:
16, 9, 12, 7, 10, 8, 11, 14, 13, 15, 6, 4, 5, 1, 2, and 3.

Each element a in the sorting indicates an a^{th} column of the mother matrix.

Optionally, in an embodiment, the mother code length is 648, the code rate is 2/3, and in descending order of repetition priorities, repetition priorities of columns, in the mother matrix, corresponding to information bits, are sorted as follows:
16, 9, 12, 7, 10, 8, 11, 14, 13, 15, 6, 4, 5, 1, 2, and 3.

Each element a in the sorting indicates an a^{th} column of the mother matrix.

Optionally, in an embodiment, the mother code length is 1944, the code rate is 3/4, and in descending order of repetition priorities, repetition priorities of columns, in the mother matrix, corresponding to information bits, are sorted as follows:
12, 16, 11, 10, 14, 17, 15, 8, 13, 18, 7, 9, 1, 2, 3, 4, 5, and 6.

Each element a in the sorting indicates an a^{th} column of the mother matrix.

Optionally, in an embodiment, the mother code length is 1296, the code rate is 3/4, and in descending order of repetition priorities, repetition priorities of columns, in the mother matrix, corresponding to information bits, are sorted as follows:
9, 11, 13, 15, 17, 8, 10, 12, 14, 16, 18, 1, 2, 3, 4, 5, 6, and 7.

Each element a in the sorting indicates an a^{th} column of the mother matrix.

Optionally, in an embodiment, the mother code length is 648, the code rate is 3/4, and in descending order of repetition priorities, repetition priorities of columns, in the mother matrix, corresponding to information bits, are sorted as follows:
18, 13, 15, 16, 12, 14, 17, 10, 6, 7, 8, 11, 9, 1, 2, 3, 4, and 5.

Each element a in the sorting indicates an a^{th} column of the mother matrix.

Optionally, in an embodiment, the mother code length is 1944, the code rate is 5/6, and in descending order of repetition priorities, repetition priorities of columns, in the mother matrix, corresponding to information bits, are sorted as follows:
12, 14, 15, 17, 19, 13, 20, 11, 16, 18, 1, 2, 3, 4, 5, 6, 7, 8, 9, and 10.

Each element a in the sorting indicates an a^{th} column of the mother matrix.

Optionally, in an embodiment, the mother code length is 1296, the code rate is 5/6, and in descending order of repetition priorities, repetition priorities of columns, in the mother matrix, corresponding to information bits, are sorted as follows:
17, 20, 19, 18, 1, 2, 3, 4, 5, 6, 7, 8, 9, 10, 11, 12, 13, 14, 15, and 16.

Each element a in the sorting indicates an a^{th} column of the mother matrix.

Optionally, in an embodiment, the mother code length is 648, the code rate is 5/6, and in descending order of repetition priorities, repetition priorities of columns, in the mother matrix, corresponding to information bits, are sorted as follows:
13, 1, 2, 3, 4, 5, 6, 7, 8, 9, 10, 11, 12, 14, 15, 16, 17, 18, 19, and 20.

Each element a in the sorting indicates an a^{th} column of the mother matrix.

Optionally, in an embodiment, the processing unit 1100 is specifically configured to:
if L < z, select and repeat L information bits from z information bits, in the check matrix, corresponding to a column with a highest repetition priority in the mother matrix;
if L = m × z, selecting and repeating, by the transmit end in descending order of repetition priorities from the mother matrix, mz information bits, in the check matrix, corresponding to first m columns with higher repetition priorities, where m is a positive integer; and
if (m - 1) × z < L < m × z, selecting and repeating, by the transmit end in descending order of repetition priorities from the mother matrix, (m - 1) × z information bits, in the check matrix, corresponding to first (m - 1) columns with higher repetition priorities and p information bits in z information bits, in the check matrix, corresponding to an m^{th} column, where L = (m - 1) × z + p, p ≥ 1, p is an integer, m > 1, and m is an integer.

Optionally, in an embodiment, the transceiver unit 1200 is further configured to send the first LDPC codeword.

The processing unit 1100 is configured to determine that the first LDPC codeword is not successfully decoded by a receive end.

The transceiver unit 1200 is specifically configured to repeatedly send, in descending order of repetition priorities based on a quantity L of bits that need to be repeated and the order of repetition priorities of the K information bits, L information bits included in a first information bit set in the first LDPC codeword.

The processing unit 1100 is further configured to determine that all information bits included in the first LDPC codeword are repeatedly sent and a receive end still does not successfully perform decoding.

The transceiver unit 1200 is further configured to send check bits obtained after puncturing in the first LDPC codeword in an order of puncturing priorities of check bits, where a check bit with a lower puncturing priority is sent first, the puncturing priorities indicate puncturing priorities of (N - K) check bits in rate matching, N is the mother code length of the LDPC, N ≥ K, and N is an integer.

Optionally, in an embodiment, the transceiver unit 1200 is further configured to send the first LDPC codeword.

The processing unit 1100 is further configured to determine that the first LDPC codeword is not successfully decoded by a receive end.

The sending unit 1200 is further configured to send check bits in the first LDPC codeword in an order of puncturing priorities of check bits, where a check bit with a lower puncturing priority is sent first, the puncturing priorities indicate puncturing priorities of (N - K) check bits in rate matching, N is the mother code length of the LDPC, N ≥ K, and N is an integer.

The processing unit 1100 is further configured to determine that all check bits, obtained after puncturing, of the first LDPC codeword are sent and a receive end still does not successfully perform decoding.

The transceiver unit 1200 is further configured to send information bits of the first LDPC codeword based on repetition priorities of the K information bits.

Optionally, the communication apparatus 1000 may be a transmit end, or the communication apparatus 1000 may be a component, a module, or the like that is inside the transmit end and that has a function for implementing each method embodiment.

In an implementation, the communication apparatus 1000 is the transmit end in the foregoing method embodiments, and the communication apparatus 1000 may have any function of the transmit end in the method embodiments. In this case, the processing unit 1100 may be a processor. The transceiver unit 1200 may be a transceiver. The transceiver may specifically include a receiver device and a transmitter device. The receiver device is configured to perform a receiving function, and the transmitter device is configured to perform a transmitting function.

Optionally, in another implementation, the communication apparatus 1000 may be a circuit system at a transmit end. In this case, the processing unit 1100 may be a chip, a logic circuit, an integrated circuit, a processing circuit, a system on chip (system on chip, SoC) chip, or the like. The transceiver unit 1200 may be a communication interface. The communication interface may be an interface circuit, an input/output interface, a pin that is on the chip and that is used to transmit a signal, or the like.

In an embodiment, the communication apparatus 1000 may be an encoder at a transmit end.

In the foregoing embodiments, a function of the processing unit 1100 may be implemented by hardware, or may be implemented by hardware by executing corresponding software.

For example, the processing unit 1100 may include one or more processors. The one or more processors are configured to read and execute a computer program or instructions stored in a memory, so that operations and/or processing performed by the transmit end in the method embodiments are performed. The memory is located outside the one or more processors.

Further, the processing unit 1100 may further include one or more memories. The one or more processors are connected to the one or more memories by using a circuit/wire. The one or more processors may read a computer program or instructions stored in the one or more memories, so that operations and/or processing performed by the transmit end in the method embodiments of this application are performed.

For another example, the processing unit 1100 is a processor, and the transceiver unit 1200 may be an interface circuit. The interface circuit is configured to receive computer code or instructions, and transmit the computer code or the instructions to the processor. The processor executes the computer code or the instructions, so that operations and/or processing performed by the transmit end in the method embodiments of this application are/is performed.

Optionally, the processing unit 1100 may alternatively be a processing circuit, a logic circuit, or the like.

In addition, this application further provides a computer-readable storage medium. The computer-readable storage medium stores computer instructions. When the computer instructions are run on a computer, the LDPC rate matching method provided in this application is implemented.

This application further provides a computer program product. The computer program product includes computer code or instructions. When the computer code or the instructions is run or are run on a computer, the LDPC rate matching method in the method embodiments of this application is implemented.

This application further provides a communication apparatus, including a processor and an interface circuit. The interface circuit is configured to receive computer code or instructions, and transmit the computer code or instructions to the processor, and the processor is configured to run the computer code or instructions, so that the LDPC rate matching method provided in this application is implemented.

This application further provides a chip. The chip includes one or more processors. The one or more processors are configured to execute a computer program stored in a memory, to perform operations and/or processing performed by a transmit device in any method embodiment. The memory is disposed independent of the chip.

Further, the chip may further include one or more communication interfaces. The one or more communication interfaces may be an input/output interface, an interface circuit, or the like. Further, the chip may further include one or more memories.

This application further provides a wireless communication system, including the transmit end in embodiments of this application.

Optionally, the transmit end may be a network device (for example, a base station) or a terminal device. This is not limited.

The processor in this embodiment of this application may be an integrated circuit chip, and has a signal processing capability. In an implementation process, steps of the foregoing method embodiments may be implemented by using an integrated logic circuit of hardware in the processor or by using instructions in a form of software. The processor may be a general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or a transistor logic device, or a discrete hardware component. The general-purpose processor may be a microprocessor, or the processor may be any conventional processor or the like. The steps of the methods disclosed in embodiments of this application may be directly presented as being performed and completed by a hardware encoding processor, or performed and completed by a combination of hardware and a software module in an encoding processor. The software module may be located in a mature storage medium in the art, such as a random access memory, a flash memory, a read-only memory, a programmable read-only memory, an electrically erasable programmable memory, or a register. The storage medium is located in a memory, and the processor reads information in the memory and completes the steps in the foregoing methods in combination with the hardware of the processor.

The memory in this embodiment of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through examples but not limitative description, RAMs in many forms are available, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DRRAM). It should be noted that the memory of the systems and methods described in this specification includes but is not limited to these and any memory of another appropriate type.

The terms such as "unit", and "system" used in this specification indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As shown in figures, both a computing device and an application that runs on a computing device may be components. One or more components may reside within the process and/or the execution thread. The components may be located on one computer and/or distributed between two or more computers. In addition, these components may be executed from various computer-readable media that store various data structures. The components may communicate by using a local and/or remote process based on a signal having one or more data packets (for example, data from two components interacting with another component in a local system, a distributed system, and/or another network, such as the Internet for interacting with another system by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on a particular application and a design constraint condition of the technical solutions. A person skilled in the art may use different methods to implement the described functions for each particular application, but it should not be considered that the implementation goes beyond the scope of this application.

It may be clearly understood by a person skilled in the art that, for convenient and brief description, for a detailed working process of the foregoing system, apparatus, and unit, refer to a corresponding process in the foregoing method embodiment. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electronic form, a mechanical form, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in the embodiments of this application. The foregoing storage medium includes any medium that can store program code, such as a USB flash drive, a removable hard disk, a read-only memory, a random access memory, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application provided that it falls within the scope of protection as defined by the appended claims.

## Claims

1. An LDPC code rate matching method, comprising:
performing (610), by a transmit end, rate matching on a first low-density parity-check, LDPC codeword at a first code rate based on an order of repetition priorities of K information bits of a mother code of an LDPC in rate matching, to obtain a second LDPC codeword at a second code rate, wherein K is a positive integer and in the order of repetition priorities, an information bit with higher sensitivity has a lower repetition priority, and an information bit with a lower sensitivity has a higher repetition priority, wherein the sensitivity of a codeword bit is defined as follows: first, a fixed signal source is an all-zero signal source; in a noise-free case, iterative calculation for a specific quantity of iterations is performed on an LDPC codeword on which rate matching has not been performed, and after iterative decoding is converged, an absolute value |LLR| of a log-likelihood ratio, LLR, of the iterative decoding is used as a confidence feature, to determine sensitivity of a bit position; a smaller |LLR| indicates that a bit position corresponding to |LLR| is more sensitive; and
sending (620), by the transmit end, the second LDPC codeword;
wherein the performing (610), by the transmit end, rate matching on the first LDPC codeword at the first code rate based on the order of repetition priorities of the K information bits in rate matching comprises:
repeating, by the transmit end, in descending order of repetition priorities based on a quantity L of bits that need to be repeated and the order of repetition priorities of the K information bits in rate matching, L information bits comprised in a first information bit set in the first LDPC codeword, wherein
a repetition priority of an information bit with a lowest repetition priority in the L information bits comprised in the first information bit set is higher than or equal to the repetition priorities of remaining information bits in the first LDPC codeword other than the L information bits in the first information bit set, L ≤ K, and L is an integer;
the order of repetition priorities of the K information bits is:
an order of repetition priorities of columns, corresponding to information bits, in a mother matrix of a check matrix of an LDPC whose quantity of information bits is K, mother code length is N, and code rate is R, wherein each column in the mother matrix corresponds to z codeword bits of the LDPC, z = N/n, n is a total quantity of columns comprised in the mother matrix, and the check matrix of the LDPC is obtained by extending the mother matrix; and each element i in the mother matrix indicates a cyclic shift matrix of z × z, i indicates a cyclic shift value, i ≥ 0, i is an integer, N ≥ K, N is an integer, and R = K/N;
wherein the repeating, by the transmit end, in descending order of repetition priorities based on the quantity L of bits that need to be repeated and the order of repetition priorities of the K information bits in rate matching, the L information bits comprised in the first information bit set in the first LDPC codeword comprises:
if L < z, selecting and repeating, by the transmit end, from z information bits, in the check matrix, corresponding to a column with the highest repetition priority in the mother matrix, L information bits;
if L = m x z, selecting and repeating, by the transmit end, in descending order of repetition priorities from the mother matrix, mz information bits, in the check matrix, corresponding to first m columns with highest repetition priorities, wherein m is a positive integer; and
if (m - 1) x z < L < m x z, selecting and repeating, by the transmit end, in descending order of repetition priorities from the mother matrix, (m - 1) x z information bits, in the check matrix, corresponding to first (m - 1) columns with highest repetition priorities and p information bits in z information bits, in the check matrix, corresponding to an m^{th} column, wherein L = (m - 1) x z + p, p ≥ 1, p is an integer, m > 1, and m is an integer:
wherein the method further comprises:
if the first LDPC codeword is not successfully decoded by a receive end after sending, by the transmit end, the first LDPC codeword, retransmitting, by the transmit end, in descending order of repetition priorities based on a quantity t1 of bits that need to be retransmitted and the order of repetition priorities of the K information bits, t1 information bits comprised in the first information bit set in the first LDPC codeword; and
if all information bits comprised in the first LDPC codeword have been retransmitted and the receive end still does not successfully decode the information bits, the method further comprises:
sending, by the transmit end, check bits that are in the first LDPC codeword after puncturing the check bits in an order of puncturing priorities, wherein a check bit with a lower puncturing priority is sent first, the puncturing priorities indicate puncturing priorities of (N - K) check bits in rate matching, N is the code length of the mother code of the LDPC, N ≥ K, and N is an integer, and wherein a check bit with higher sensitivity has a higher puncturing priority, and a check bit with a lower sensitivity has a lower puncturing priority.

2. The method according to claim 1, wherein the mother code length is 1944, the code rate is 1/2, and the repetition priorities of the columns in the mother matrix corresponding to the information bits are sorted as follows in descending order of repetition priorities:
10, 6, 8, 11, 4, 3, 12, 7, 2, 5, 9, and 1, wherein
each element a in the sorting indicates an a^{th} column of the mother matrix.

3. The method according to claim 1, wherein the mother code length is 1296, the code rate is 1/2, and the repetition priorities of the columns in the mother matrix corresponding to the information bits are sorted as follows in descending order of repetition priorities:
8, 12, 7, 3, 11, 10, 4, 6, 2, 5, 9, and 1, wherein
each element a in the sorting indicates an a^{th} column of the mother matrix.

4. The method according to claim 1, wherein the mother code length is 648, the code rate is 1/2, and the repetition priorities of the columns in the mother matrix corresponding to the information bits are sorted as follows in descending order of repetition priorities:
8, 6, 12, 11, 2, 3, 10, 7, 4, 1, 5, and 9, wherein
each element a in the sorting indicates an a^{th} column of the mother matrix.

5. The method according to claim 1, wherein the mother code length is 1944, the code rate is 2/3, and the repetition priorities of the columns in the mother matrix corresponding to the information bits are sorted as follows in descending order of repetition priorities:
16, 8, 15, 12, 9, 10, 14, 6, 13, 11, 7, 5, 1, 2, 3, and 4, wherein
each element a in the sorting indicates an a^{th} column of the mother matrix.

6. The method according to claim 1, wherein the mother code length is 1296, the code rate is 2/3, and the repetition priorities of the columns in the mother matrix corresponding to the information bits are sorted as follows in descending order of repetition priorities:
16, 9, 12, 7, 10, 8, 11, 14, 13, 15, 6, 4, 5, 1, 2, and 3, wherein
each element a in the sorting indicates an a^{th} column of the mother matrix.

7. The method according to any one of claims 1 to 6, wherein before the retransmitting, by the transmit end in descending order of repetition priorities based on a quantity t1 of bits that need to be retransmitted and the order of repetition priorities of the K information bits, t1 information bits comprised in the first information bit set in the first LDPC codeword, the method further comprises:
sending, by the transmit end, the first LDPC codeword; and
if the first LDPC codeword is not successfully decoded by a receive end, sending, by the transmit end, check bits that are in the first LDPC codeword after puncturing the check bits in an order of puncturing priorities, wherein a check bit with a lower puncturing priority is sent first, the puncturing priorities indicate puncturing priorities of (N - K) check bits in rate matching, N is the code length of the mother code of the LDPC, N > K, and N is an integer; and
the retransmitting, by the transmit end in descending order of repetition priorities based on a quantity t1 of bits that need to be retransmitted and the order of repetition priorities of the K information bits, t1 information bits comprised in the first information bit set in the first LDPC codeword comprises:
if all check bits, obtained after puncturing, of the first LDPC codeword are sent and the receive end still does not successfully perform decoding, retransmitting, by the transmit end, the information bits of the first LDPC codeword based on the repetition priorities of the K information bits.

8. A communication apparatus, configured to perform a method as claimed in any one of claims 1 to 7.

9. The communication apparatus according to claim 8, comprising a processor and an interface circuit, wherein the interface circuit is configured to receive computer code or instructions, and transmit the computer code or the instructions to the processor, and when the processor runs the computer code or the instructions, the method according to any one of claims 1 to 7 is implemented.

10. A computer-readable storage medium, wherein the computer-readable storage medium stores computer instructions; and when the computer instructions are run on a computer, the method according to any one of claims 1 to 7 is implemented.

11. A program which makes a computer perform a method as claimed in any one of claims 1 to 7

## Patentansprüche

1. LDPC-Coderatenanpassungsverfahren, das umfasst:
Durchführen (610), durch eine Sendeseite, einer Ratenanpassung an einem ersten Low-Density-Parity-Check(LDPC)-Codewort bei einer ersten Coderate basierend auf einer Reihenfolge von Wiederholungsprioritäten von K Informationsbits eines Muttercodes eines LDPC bei der Ratenanpassung, um ein zweites LDPC-Codewort bei einer zweiten Coderate zu erhalten, wobei K eine positive ganze Zahl ist und in der Reihenfolge von Wiederholungsprioritäten ein Informationsbit mit höherer Empfindlichkeit eine niedrigere Wiederholungspriorität aufweist, und ein Informationsbit mit einer niedrigeren Empfindlichkeit eine höhere Wiederholungspriorität aufweist, wobei die Empfindlichkeit eines Codewortbits wie folgt definiert ist:
erstens, ist eine feste Signalquelle eine Null-Signal-Quelle; in einem rauschfreien Fall wird eine iterative Berechnung für eine spezifische Anzahl von Iterationen an einem LDPC-Codewort durchgeführt, an dem keine Ratenanpassung durchgeführt wurde, und nachdem eine iterative Decodierung konvergiert wird, wird ein Absolutwert |LLR| eines Log-Likelihood-Verhältnisses (LLR) der iterativen Decodierung als ein Vertrauensmerkmal verwendet, um die Empfindlichkeit einer Bitposition zu bestimmen; ein kleinerer |LLR| zeigt an, dass eine Bitposition, die |LLR| entspricht, empfindlicher ist; und
Übertragen (620), durch die Sendeseite, des zweiten LDPC-Codeworts;
wobei das Durchführen (610), durch die Sendeseite, der Ratenanpassung an dem ersten LDPC-Codewort bei der ersten Coderate basierend auf der Reihenfolge von Wiederholungsprioritäten der K Informationsbits in der Ratenanpassung umfasst:
Wiederholen, durch die Sendeseite, in absteigender Reihenfolge von Wiederholungsprioritäten basierend auf einer Anzahl L von Bits, die wiederholt werden müssen, und der Reihenfolge von Wiederholungsprioritäten der K Informationsbits bei der Ratenanpassung, von L Informationsbits, die in einem ersten Informationsbitsatz in dem ersten LDPC-Codewort umfasst sind, wobei
eine Wiederholungspriorität eines Informationsbits mit einer niedrigsten Wiederholungspriorität in den L Informationsbits, die in dem ersten Informationsbitsatz umfasst sind, höher als oder gleich den Wiederholungsprioritäten verbleibender Informationsbits in dem ersten LDPC-Codewort außer den L Informationsbits in dem ersten Informationsbitsatz ist, L ≤ K, und L eine ganze Zahl ist;
die Reihenfolge von Wiederholungsprioritäten der K Informationsbits ist:
eine Reihenfolge von Wiederholungsprioritäten von Spalten, die Informationsbits entsprechen, in einer Muttermatrix einer Prüfmatrix eines LDPC, dessen Anzahl von Informationsbits K ist, Muttercodelänge N ist, und Coderate R ist, wobei jede Spalte in der Muttermatrix z Codewortbits des LDPC entspricht, z = N/n, n eine Gesamtanzahl von Spalten, die in der Muttermatrix umfasst sind, ist, und die Prüfmatrix des LDPC durch Erweitern der Muttermatrix erhalten wird; und jedes Element i in der Muttermatrix eine zyklische Verschiebungsmatrix von z × z anzeigt, i einen zyklischen Verschiebungswert anzeigt, i ≥ 0, i eine ganze Zahl ist, N ≥ K, N eine ganze Zahl ist, und R = K/N;
wobei das Wiederholen, durch die Sendeseite, in absteigender Reihenfolge von Wiederholungsprioritäten basierend auf der Anzahl L von Bits, die wiederholt werden müssen, und der Reihenfolge von Wiederholungsprioritäten der K Informationsbits bei der Ratenanpassung, der L Informationsbits, die in dem ersten Informationsbitsatz in dem ersten LDPC-Codewort umfasst sind, umfasst:
falls L < z, Auswählen und Wiederholen, durch die Sendeseite, aus z Informationsbits, in der Prüfmatrix, die einer Spalte mit der höchsten Wiederholungspriorität in der Muttermatrix entspricht, von L Informationsbits;
falls L = m × z, Auswählen und Wiederholen, durch die Sendeseite, in absteigender Reihenfolge von Wiederholungsprioritäten aus der Muttermatrix, von mz Informationsbits, in der Prüfmatrix, die ersten m Spalten mit höchsten Wiederholungsprioritäten entspricht, wobei m eine positive ganze Zahl ist; und
falls (m - 1) × z < L < m × z, Auswählen und Wiederholen, durch die Sendeseite, in absteigender Reihenfolge von Wiederholungsprioritäten aus der Muttermatrix, von (m - 1) × z Informationsbits, in der Prüfmatrix, die ersten (m - 1) Spalten mit höchsten Wiederholungsprioritäten entspricht, und p Informationsbits in z Informationsbits, in der Prüfmatrix, die einer m-ten Spalte entspricht, wobei L = (m - 1) × z + p, p ≥ 1, p eine ganze Zahl ist, m > 1, und m eine ganze Zahl ist:
wobei das Verfahren ferner umfasst:
falls das erste LDPC-Codewort durch eine Empfangsseite nach dem Übertragen, durch die Sendeseite, des ersten LDPC-Codeworts nicht erfolgreich decodiert wird, erneutes Senden, durch die Sendeseite, in absteigender Reihenfolge von Wiederholungsprioritäten basierend auf einer Anzahl t1 von Bits, die erneut gesendet werden müssen, und der Reihenfolge von Wiederholungsprioritäten der K Informationsbits, von t1 Informationsbits, die in dem ersten Informationsbitsatz in dem ersten LDPC-Codewort umfasst sind; und
falls alle Informationsbits, die in dem ersten LDPC-Codewort umfasst sind, erneut gesendet wurden und die Empfangsseite die Informationsbits immer noch nicht erfolgreich decodiert, das Verfahren ferner umfasst:
Übertragen, durch die Sendeseite, von Prüfbits, die sich in dem ersten LDPC-Codewort nach einem Punktieren der Prüfbits in einer Reihenfolge von Punktierungsprioritäten befinden, wobei ein Prüfbit mit einer niedrigeren Punktierungspriorität zuerst übertragen wird, die Punktierungsprioritäten Punktierungsprioritäten von (N - K) Prüfbits bei der Ratenanpassung anzeigen, N die Codelänge des Muttercodes des LDPC ist, N ≥ K, und N eine ganze Zahl ist, und wobei ein Prüfbit mit höherer Empfindlichkeit eine höhere Punktierungspriorität aufweist, und ein Prüfbit mit einer niedrigeren Empfindlichkeit eine niedrigere Punktierungspriorität aufweist.

2. Verfahren nach Anspruch 1, wobei die Muttercodelänge 1944 beträgt, die Coderate 1/2 beträgt, und die Wiederholungsprioritäten der Spalten in der Muttermatrix, die den Informationsbits entsprechen, wie folgt in absteigender Reihenfolge von Wiederholungsprioritäten sortiert sind:
10, 6, 8, 11, 4, 3, 12, 7, 2, 5, 9 und 1, wobei
jedes Element a in der Sortierung eine a-te Spalte der Muttermatrix anzeigt.

3. Verfahren nach Anspruch 1, wobei die Muttercodelänge 1296 beträgt, die Coderate 1/2 beträgt, und die Wiederholungsprioritäten der Spalten in der Muttermatrix, die den Informationsbits entsprechen, wie folgt in absteigender Reihenfolge der Wiederholungsprioritäten sortiert sind:
8, 12, 7, 3, 11, 10, 4, 6, 2, 5, 9 und 1, wobei
jedes Element a in der Sortierung eine a-te Spalte der Muttermatrix anzeigt.

4. Verfahren nach Anspruch 1, wobei die Muttercodelänge 648 beträgt, die Coderate 1/2 beträgt, und die Wiederholungsprioritäten der Spalten in der Muttermatrix, die den Informationsbits entsprechen, wie folgt in absteigender Reihenfolge der Wiederholungsprioritäten sortiert sind:
8, 6, 12, 11, 2, 3, 10, 7, 4, 1, 5 und 9, wobei
jedes Element a in der Sortierung eine a-te Spalte der Muttermatrix anzeigt.

5. Verfahren nach Anspruch 1, wobei die Muttercodelänge 1944 beträgt, die Coderate 2/3 beträgt, und die Wiederholungsprioritäten der Spalten in der Muttermatrix, die den Informationsbits entsprechen, wie folgt in absteigender Reihenfolge der Wiederholungsprioritäten sortiert sind:
16, 8, 15, 12, 9, 10, 14, 6, 13, 11, 7, 5, 1, 2, 3 und 4, wobei
jedes Element a in der Sortierung eine a-te Spalte der Muttermatrix anzeigt.

6. Verfahren nach Anspruch 1, wobei die Muttercodelänge 1296 beträgt, die Coderate 2/3 beträgt, und die Wiederholungsprioritäten der Spalten in der Muttermatrix, die den Informationsbits entsprechen, wie folgt in absteigender Reihenfolge der Wiederholungsprioritäten sortiert sind:
16, 9, 12, 7, 10, 8, 11, 14, 13, 15, 6, 4, 5, 1, 2 und 3, wobei
jedes Element a in der Sortierung eine a-te Spalte der Muttermatrix anzeigt.

7. Verfahren nach einem der Ansprüche 1 bis 6, wobei vor dem erneuten Senden, durch die Sendeseite in absteigender Reihenfolge von Wiederholungsprioritäten basierend auf einer Anzahl t1 von Bits, die erneut gesendet werden müssen, und der Reihenfolge von Wiederholungsprioritäten der K Informationsbits, von t1 Informationsbits, die in dem ersten Informationsbitsatz in dem ersten LDPC-Codewort umfasst sind, das Verfahren ferner umfasst:
Übertragen, durch die Sendeseite, des ersten LDPC-Codeworts; und
falls das erste LDPC-Codewort durch eine Empfangsseite nicht erfolgreich decodiert wird, Übertragen, durch die Sendeseite, von Prüfbits, die sich in dem ersten LDPC-Codewort nach dem Punktieren der Prüfbits in einer Reihenfolge von Punktierungsprioritäten befinden, wobei ein Prüfbit mit einer niedrigeren Punktierungspriorität zuerst übertragen wird, die Punktierungsprioritäten Punktierungsprioritäten von (N - K) Prüfbits bei der Ratenanpassung anzeigen, N die Codelänge des Muttercodes des LDPC ist, N > K, und N eine ganze Zahl ist; und
das erneute Senden, durch die Sendeseite in absteigender Reihenfolge von Wiederholungsprioritäten basierend auf einer Anzahl t1 von Bits, die erneut gesendet werden müssen, und der Reihenfolge von Wiederholungsprioritäten der K Informationsbits, von t1 Informationsbits, die in dem ersten Informationsbitsatz in dem ersten LDPC-Codewort umfasst sind, umfasst:
falls alle Prüfbits, die nach dem Punktieren erhalten werden, des ersten LDPC-Codeworts übertragen werden und die Empfangsseite immer noch nicht erfolgreich die Decodierung durchführt, erneutes Senden, durch die Sendeseite, der Informationsbits des ersten LDPC-Codeworts basierend auf den Wiederholungsprioritäten der K Informationsbits.

8. Kommunikationseinrichtung, die konfiguriert ist, um ein Verfahren nach einem der Ansprüche 1 bis 7 durchzuführen.

9. Kommunikationseinrichtung nach Anspruch 8, die einen Prozessor und eine Schnittstellenschaltung umfasst, wobei die Schnittstellenschaltung konfiguriert ist, um Computercode oder Anweisungen zu empfangen, und den Computercode oder die Anweisungen an den Prozessor zu senden, und wenn der Prozessor den Computercode oder die Anweisungen ausführt, das Verfahren nach einem der Ansprüche 1 bis 7 implementiert wird.

10. Computerlesbares Speicherungsmedium, wobei das computerlesbare Speicherungsmedium Computeranweisungen speichert; und wenn die Computeranweisungen auf einem Computer ausgeführt werden, das Verfahren nach einem der Ansprüche 1 bis 7 implementiert wird.

11. Programm, das einen Computer veranlasst, ein Verfahren nach einem der Ansprüche 1 bis 7 durchzuführen.

## Revendications

1. Procédé d'adaptation de débit de code LDPC, comprenant :
la réalisation (610), par une extrémité de transmission, d'une adaptation de débit sur un premier mot de code de contrôle de parité à faible densité, LDPC, à un premier débit de code sur la base d'un ordre de priorités de répétition de K bits d'information d'un code mère d'un LDPC en adaptation de débit, pour obtenir un second mot de code LDPC à un second débit de code, dans lequel K est un nombre entier positif et dans l'ordre de priorités de répétition, un bit d'information ayant une sensibilité plus élevée a une priorité de répétition plus faible, et un bit d'information ayant une sensibilité plus faible a une priorité de répétition plus élevée, dans lequel la sensibilité d'un bit de mot de code est définie comme suit :
premièrement, une source de signal fixe est une source de signal entièrement nulle ; dans un cas sans bruit, un calcul itératif pour une quantité spécifique d'itérations est effectué sur un mot de code LDPC sur lequel aucune adaptation de débit n'a été effectuée, et après convergence du décodage itératif, une valeur absolue |LLR| d'un rapport de vraisemblance logarithmique, LLR, du décodage itératif est utilisée comme caractéristique de confiance, pour déterminer la sensibilité d'une position de bit ; un |LLR| plus petit indique qu'une position de bit correspondant à |LLR| est plus sensible ; et
l'envoi (620), par l'extrémité de transmission, du second mot de code LDPC ;
dans lequel la réalisation (610), par l'extrémité de transmission, d'une adaptation de débit sur le premier mot de code LDPC au premier débit de code sur la base de l'ordre de priorités de répétition des K bits d'information en adaptation de débit comprend :
la répétition, par l'extrémité de transmission, en ordre décroissant de priorités de répétition sur la base d'une quantité L de bits qui doivent être répétés et de l'ordre de priorités de répétition des K bits d'information en adaptation de débit, de L bits d'information compris dans un premier ensemble de bits d'information dans le premier mot de code LDPC, dans lequel
une priorité de répétition d'un bit d'information ayant une priorité de répétition la plus faible dans les L bits d'information compris dans le premier ensemble de bits d'information est supérieure ou égale aux priorités de répétition de bits d'information restants dans le premier mot de code LDPC, autre que les L bits d'information dans le premier ensemble de bits d'information, L ≤ K, et L est un nombre entier ;
l'ordre de priorités de répétition des K bits d'information est :
un ordre de priorités de répétition de colonnes, correspondant à des bits d'information, dans une matrice mère d'une matrice de contrôle d'un LDPC dont la quantité de bits d'information est K, la longueur de code mère est N, et le débit de code est R, dans lequel chaque colonne dans la matrice mère correspond à z bits de mot de code du LDPC, z = N/n, n est une quantité totale de colonnes comprises dans la matrice mère, et la matrice de contrôle du LDPC est obtenue en étendant la matrice mère ; et chaque élément i dans la matrice mère indique une matrice de décalage cyclique de z × z, i indique une valeur de décalage cyclique, i ≥ 0, i est un nombre entier, N ≥ K, N est un nombre entier, et R = K/N ;
dans lequel la répétition, par l'extrémité de transmission, en ordre décroissant de priorités de répétition sur la base de la quantité L de bits qui doivent être répétés et de l'ordre de priorités de répétition des K bits d'information en adaptation de débit, des L bits d'information compris dans le premier ensemble de bits d'information dans le premier mot de code LDPC comprend :
si L < z, la sélection et la répétition, par l'extrémité de transmission, parmi z bits d'information, dans la matrice de contrôle, correspondant à une colonne ayant la priorité de répétition la plus élevée dans la matrice mère, de L bits d'information ;
si L = m × z, la sélection et la répétition, par l'extrémité de transmission, en ordre décroissant de priorités de répétition à partir de la matrice mère, de mz bits d'information, dans la matrice de contrôle, correspondant à m premières colonnes ayant les priorités de répétition les plus élevées, dans lequel m est un nombre entier positif ; et
si (m - 1) × z < L < m × z, la sélection et la répétition, par l'extrémité de transmission, en ordre décroissant de priorités de répétition à partir de la matrice mère, de (m - 1) × z bits d'information, dans la matrice de contrôle, correspondant à (m - 1) premières colonnes ayant les priorités de répétition les plus élevées et de p bits d'information dans z bits d'information, dans la matrice de contrôle, correspondant à une m^{e} colonne, dans lequel L = (m - 1) × z + p, p ≥ 1, p est un nombre entier, m > 1, et m est un nombre entier : dans lequel le procédé comprend en outre :
si le premier mot de code LDPC n'est pas décodé avec succès par une extrémité de réception après l'envoi, par l'extrémité de transmission, du premier mot de code LDPC, la retransmission, par l'extrémité de transmission, en ordre décroissant de priorités de répétition sur la base d'une quantité t1 de bits qui doivent être retransmis et de l'ordre de priorité de répétition des K bits d'information, de t1 bits d'information compris dans le premier ensemble de bits d'information dans le premier mot de code LDPC ; et
si tous les bits d'information compris dans le premier mot de code LDPC ont été retransmis et que l'extrémité de réception ne parvient toujours pas à décoder les bits d'information, le procédé comprend en outre :
l'envoi, par l'extrémité de transmission, de bits de contrôle qui sont dans le premier mot de code LDPC après perforation des bits de contrôle dans un ordre de priorités de perforation, dans lequel un bit de contrôle ayant une priorité de perforation inférieure est envoyé en premier, les priorités de perforation indiquent des priorités de perforation de (N - K) bits de contrôle en adaptation de débit, N est la longueur de code du code mère du LDPC, N ≥ K, et N est un nombre entier, et dans lequel un bit de contrôle ayant une sensibilité plus élevée a une priorité de perforation plus élevée, et un bit de contrôle ayant une sensibilité plus faible a une priorité de perforation plus faible.

2. Procédé selon la revendication 1, dans lequel la longueur de code mère est de 1944, le débit de code est de 1/2, et les priorités de répétition des colonnes dans la matrice mère correspondant aux bits d'information sont triées comme suit en ordre décroissant de priorités de répétition :
10, 6, 8, 11, 4, 3, 12, 7, 2, 5, 9, et 1, dans lequel
chaque élément a dans le tri indique une a^{e} colonne de la matrice mère.

3. Procédé selon la revendication 1, dans lequel la longueur de code mère est de 1296, le débit de code est de 1/2, et les priorités de répétition des colonnes dans la matrice mère correspondant aux bits d'information sont triées comme suit en ordre décroissant de priorités de répétition :
8, 12, 7, 3, 11, 10, 4, 6, 2, 5, 9, et 1, dans lequel
chaque élément a dans le tri indique une a^{e} colonne de la matrice mère.

4. Procédé selon la revendication 1, dans lequel la longueur de code mère est de 648, le débit de code est de 1/2, et les priorités de répétition des colonnes dans la matrice mère correspondant aux bits d'information sont triées comme suit en ordre décroissant de priorités de répétition :
8, 6, 12, 11, 2, 3, 10, 7, 4, 1, 5, et 9, dans lequel
chaque élément a dans le tri indique une a^{e} colonne de la matrice mère.

5. Procédé selon la revendication 1, dans lequel la longueur de code mère est de 1944, le débit de code est de 2/3, et les priorités de répétition des colonnes dans la matrice mère correspondant aux bits d'information sont triées comme suit en ordre décroissant de priorités de répétition :
16, 8, 15, 12, 9, 10, 14, 6, 13, 11, 7, 5, 1, 2, 3, et 4, dans lequel
chaque élément a dans le tri indique une a^{e} colonne de la matrice mère.

6. Procédé selon la revendication 1, dans lequel la longueur de code mère est de 1296, le débit de code est de 2/3, et les priorités de répétition des colonnes dans la matrice mère correspondant aux bits d'information sont triées comme suit en ordre décroissant de priorités de répétition :
16, 9, 12, 7, 10, 8, 11, 14, 13, 15, 6, 4, 5, 1, 2, et 3, dans lequel
chaque élément a dans le tri indique une a^{e} colonne de la matrice mère.

7. Procédé selon l'une quelconque des revendications 1 à 6, dans lequel, avant la retransmission, par l'extrémité de transmission, en ordre décroissant de priorités de répétition sur la base d'une quantité t1 de bits qui doivent être retransmis et de l'ordre de priorités de répétition des K bits d'information, de t1 bits d'information compris dans le premier ensemble de bits d'information dans le premier mot de code LDPC, le procédé comprend en outre :
l'envoi, par l'extrémité de transmission, du premier mot de code LDPC ; et
si le premier mot de code LDPC n'est pas décodé avec succès par une extrémité de réception, l'envoi, par l'extrémité de transmission, de bits de contrôle qui sont dans le premier mot de code LDPC après perforation des bits de contrôle dans un ordre de priorités de perforation, dans lequel un bit de contrôle ayant une priorité de perforation inférieure est envoyé en premier, les priorités de perforation indiquent des priorités de perforation de (N - K) bits de contrôle en adaptation de débit, N représente la longueur de code du code mère du LDPC, N > K, et N représente un nombre entier ; et
la retransmission, par l'extrémité de transmission en ordre décroissant de priorités de répétition sur la base d'une quantité t1 de bits qui doivent être retransmis et de l'ordre de priorités de répétition des K bits d'information, de t1 bits d'information compris dans le premier ensemble de bits d'information dans le premier mot de code LDPC comprend :
si tous les bits de contrôle, obtenus après perforation, du premier mot de code LDPC sont envoyés et que l'extrémité de réception ne parvient toujours pas à effectuer le décodage, la retransmission, par l'extrémité de transmission, des bits d'information du premier mot de code LDPC sur la base des priorités de répétition des K bits d'information.

8. Appareil de communication, configuré pour effectuer un procédé selon l'une quelconque des revendications 1 à 7.

9. Appareil de communication selon la revendication 8, comprenant un processeur et un circuit d'interface, dans lequel le circuit d'interface est configuré pour recevoir un code informatique ou des instructions, et transmettre le code informatique ou les instructions au processeur, et lorsque le processeur exécute le code informatique ou les instructions, le procédé selon l'une quelconque des revendications 1 à 7 est mis en œuvre.

10. Support de stockage lisible par ordinateur, dans lequel le support de stockage lisible par ordinateur stocke des instructions informatiques ; et lorsque les instructions informatiques sont exécutées sur un ordinateur, le procédé selon l'une quelconque des revendications 1 à 7 est mis en œuvre.

11. Programme qui amène un ordinateur à effectuer un procédé selon l'une quelconque des revendications 1 à 7.
